(19)

Europäisches
Patentamt
European
Patent Office
Office européen
des brevets

(11) **EP 1 884 580 A2**

(12) **EUROPEAN PATENT APPLICATION**

(43) Date of publication:
**06.02.2008 Bulletin 2008/06**

(51) Int Cl.:
*C30B 25/02* (2006.01)    *C30B 29/40* (2006.01)

(21) Application number: **07015013.1**

(22) Date of filing: **31.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **02.08.2006 JP 2006210506**

(71) Applicant: **Sumitomo Electric Industries, Ltd.**
**Chuo-ku**
**Osaka 541 0041 (JP)**

(72) Inventors:
• **Hirota, Ryu**
**Itami-shi**
**Hyogo 664-0016 (JP)**

• **Motoki, Kensaku**
**Itami-shi**
**Hyogo 664-0016 (JP)**
• **Nakahata, Seiji**
**Itami-shi**
**Hyogo 664-0016 (JP)**
• **Okahisa, Takuji**
**Itami-shi**
**Hyogo 664-0016 (JP)**
• **Uematsu, Koji**
**Itami-shi**
**Hyogo 664-0016 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Method of growing gallium nitride crystal**

(57)    A method of growing a gallium nitride crystal according to the present invention includes: a step of partially forming, on a ground substrate (U), a mask (M) inhibiting epitaxial growth of the crystal; and a step of epitaxially growing the crystal by vapor phase deposition on the ground substrate (U) on which the mask (M) is formed, wherein in the step of epitaxially growing the crystal, the crystal is grown under a first growth condition wherein a growth rate Vj expressed in $\mu$m/h unit and a growth temperature T expressed in absolute temperature are expressed by $(a_1 / T + b_1) < Vj < (a_2 / T + b_2)$ using coefficients $a_1 = -4.39 \times 10^5$, $b_1 = 3.87 \times 10^2$, $a_2 = -7.36 \times 10^5$, and $b_2 = 7.37 \times 10^2$. In this manner, the dislocation density in the crystal is reduced.

FIG.7

**EP 1 884 580 A2**

**Description**

BACKGROUND OF THE INVENTION

Field of the Invention

A gallium nitride based blue-violet laser is used for a large capacity optical disc of the next generation. In order to put the blue-violet laser to practical use, a gallium nitride substrate of high quality is required. The gallium nitride substrate is expected to be used for, besides the blue-violet laser, light-emitting elements such as a light-emitting diode, a laser diode and the like, electronic elements such as a rectifier, a bipolar transistor, a field-effect transistor, an HEMT (High Electron Mobility Transistor) and the like, semiconductor sensors such as a temperature sensor, a pressure sensor, a radiation sensor, a visible-ultraviolet light detector and the like, an SAW (Surface Acoustic Wave) device, an acceleration sensor, MEMS (Micro-Electro-Mechanical System) parts, a piezoelectric vibrator, a resonator, a piezoelectric actuator and the like. The present invention relates to a method of growing a gallium nitride crystal for manufacturing a gallium nitride substrate of high quality.

Description of the Background Art

A gallium nitride (GaN) based semiconductor laser having a wavelength of 405 nm is employed as a blue-violet laser used in recording and reproducing data on/from a high-density optical disc. A blue-violet light emitting diode (LED) is produced by forming a thin film of GaN, InGaN or the like on a sapphire ($Al_2O_3$) substrate. Since sapphire and gallium nitride are significantly different in lattice constant, a high density of dislocation defects occur. In an LED of a low current density, defects are not increased and the LED has a long operating life, and a sapphire substrate of heterogeneous substrate having different chemical composition from gallium nitride serves enough as a ground substrate. However, it has been found that a sapphire substrate is not suitable for a semiconductor laser (laser diode; LD) of a high injection current density. Because of the high current density, defects are increased and rapid deterioration is invited. Unlike LEDs, a blue-violet laser employing a sapphire substrate has not been put to practical use.

There are no materials that are close enough to gallium nitride in the lattice constant. Recently, it has been found that a substrate on which a gallium nitride thin film is formed must itself be gallium nitride. In order to implement a blue-violet semiconductor laser, a gallium nitride substrate of a low dislocation density and of high quality is strongly requested.

However, it is very difficult to grow a gallium nitride crystal. Gallium nitride (GaN) does not easily melt when heated. Although a crystal growth method from a liquid phase to a solid phase is under development, such as the flux method that is the crystal growth from a melt, a gallium nitride crystal having the size of at least two inches of the practical level has not been produced yet. An attempt has been made to grow a gallium nitride crystal by a growth method from a gas phase in which gas is used as a material. In order to grow a crystal of a gallium nitride substrate of a large diameter and high quality having the size of practical level, various developments have been made.

The inventors of the present invention have developed and proposed a scheme in which a mask is applied on a heterogeneous ground substrate to thickly grow a gallium nitride crystal, and thereafter the heterogeneous ground substrate is removed so that a thick gallium nitride free-standing crystal is obtained.

WO99/23693, of which invention was made by the same inventors of the present invention, proposes a method in which, on a GaAs ground substrate, a mask having stripe (parallel linear) openings or circular openings is formed, on which a gallium nitride crystal is thickly grown, and the GaAs ground substrate is removed so that a gallium nitride single free-standing crystal (substrate) is obtained. The mask is a cover portion dominant mask in which a cover portion is great and holes (expose portions) are small. A crystal nucleus is formed only in each opening. As the thickness is increased, the crystal climbs on the cover portion, and it extends laterally and dislocations also extend laterally. The crystals laterally extending from adjacent openings collide and turn their growth direction upwardly. This significantly reduces dislocations. In this state, maintaining the flat plane (C-plane) upwardly, the crystal is grown.

This method can be regarded as one type of the ELO (Epitaxial Lateral Overgrowth) method, since the crystal is grown laterally over the mask so that dislocations are reduced. However, in the normal ELO method, firstly a thin film of GaN is formed in advance on a ground substrate of such as sapphire, then a mask of such as $SiO_2$ is formed thereon, and fine linear or dot-shaped holes are provided to the mask. When the GaN crystal is grown again, it is grown laterally over the mask from the holes where the GaN thin film of the homogeneous material is exposed. On the other hand, WO99/23693 is characterized by allowing a mask to be directly formed on a GaAs substrate of heterogeneous substrate, and GaN to be directly grown from the stripe or dot-shaped openings of the mask, and therefore it also includes a scheme called as the HELO method (Hetero-Epitaxial Lateral Overgrowth). In a gallium nitride (GaN) free-standing film formed in this manner, dislocations are significantly reduced. A method is also proposed in which, using the GaN crystal as a new substrate, a GaN crystal is further grown thereon through vapor phase deposition into a thick GaN crystal ingot, which is cut perpendicularly to the growth direction so that a plurality of GaN substrates (wafers) are manufactured. The vapor phase deposition growth of a gallium nitride crystal includes the MOCVD (Metal Organic Chemical Vapor Deposition) method, the MOC (Metal Organic Chloride) method, the HVPE (Hydride Vapor Phase Epitaxy) method, the sublimation method and the like. According to the invention of WO99/23693 by the present inventors, the HVPE method attains the fastest crystal growth rate and hence it is greatly advantageous, among others.

However, a gallium nitride crystal produced through the above-described method still has a significantly high density of dislocations and therefore is of low quality. An excellent device cannot be produced if its substrate, i.e., a gallium nitride substrate itself is not of high quality. In particular, a substrate for mass production is required to be of excellent quality, having a low density of dislocations over a wide area. As a method of reducing a dislocation density of a substrate itself for obtaining a gallium nitride substrate of high quality, the present inventors proposed the following scheme, which is disclosed in Japanese Patent Laying-Open No. 2001-102307.

In the dislocation reduction method, while a GaN crystal is thickly grown, occurring dislocation defects are gathered at a particular location so that dislocation defects in the other area is reduced.

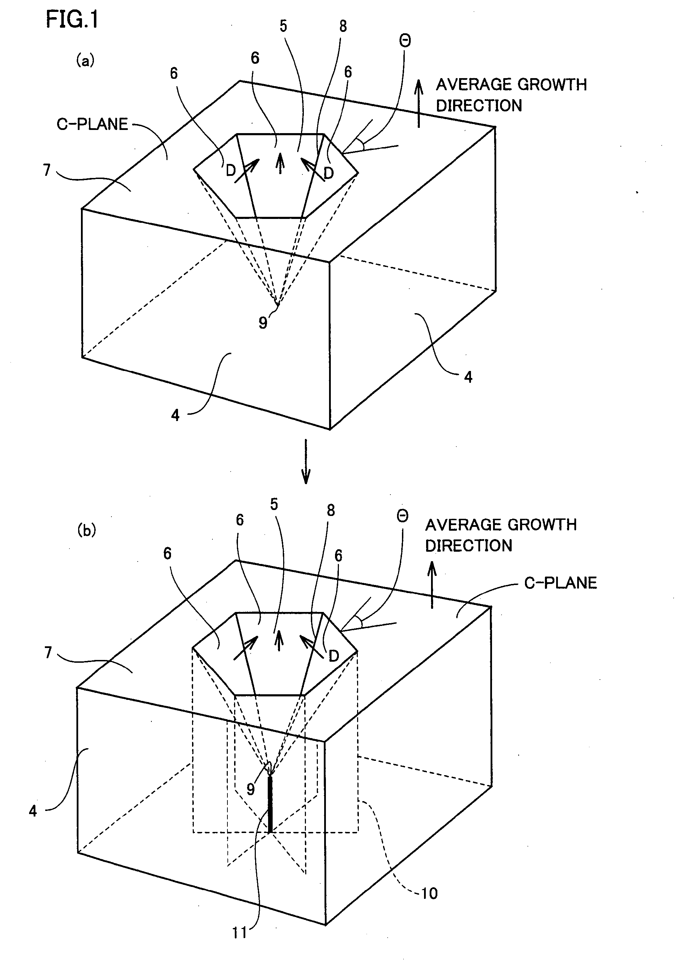

A three-dimensional facet structure, for example an inverted hexagonal pyramid pit (hole) constituted of a plurality of facet planes is formed. A crystal is grown while the facet shape is constantly maintained and the pit is unburied. Figs. 1(a) and (b) show part of a crystal 4 in which an inverted hexagonal pyramid pit 5 is formed. The top plane of crystal 4 is not perfectly flat and pits 5 are provided in several locations. The flat top plane 7 is C-plane. Pit 5 may be an inverted hexagonal pyramid, or it may be an inverted dodecagonal pyramid. Pits 5 are adjacent to each other so that facets 6 form an angle of 120° between them. Adjacent facets 6, 6 join at a ridge 8. A pit bottom 9 where ridges 8 converge is a portion where the tips of faces are gathered.

The crystal growth occurs in the direction of a normal line of a plane (meaning a ray perpendicular to a plane, hereinafter the same applies). The average growth direction is upward. At top plane (C-plane) 7, the crystal growth occurs in an upward direction (c-axis direction). At facet 6, the crystal growth occurs in a diagonal direction. An angle of facet 6 relative to C-plane is specified as $\Theta$. The facet being unburied means that a growth rate $u$ at top plane (C-plane) 7 and a growth rate $v$ at facet 6 are not the same, and that anisotropy such as $v = u\cos\Theta$ is provided.

Dislocation D extends in parallel with the growth direction of the crystal. Dislocation D having been on facet 6 moves to ridge 8 as the crystal growth progresses. Since $v < u$ and the growth rate at the facet is slower than at C-plane, dislocation D arriving at ridge 8 is fixed to ridge 8, then relatively descends along ridge 8 to converge at a pit bottom 9. As shown in Fig. 1 (b), continuously from ridge 8, a planar dislocation gathering portion 10 is formed. Dislocations D having descended along ridge 8 form a linear dislocation gathering bundle 11 continuously from pit bottom 9.

As dislocations D having been on facet 6 are gathered at planar dislocation gathering portion 10 or linear dislocation gathering bundle 11, dislocations D are gradually eliminated from facet 6. Thus, a low density of dislocations at the facet 6 portion is attained. Dislocations D at C-plane 7 are also attracted toward facet 6. If pits 5 are provided at a high density, dislocations D are swept under pit bottom 9 or ridge 8, whereby dislocations in the other area are reduced. By maintaining pit 5 unburied until the end of the growth, the dislocation reduction effect constantly continues.

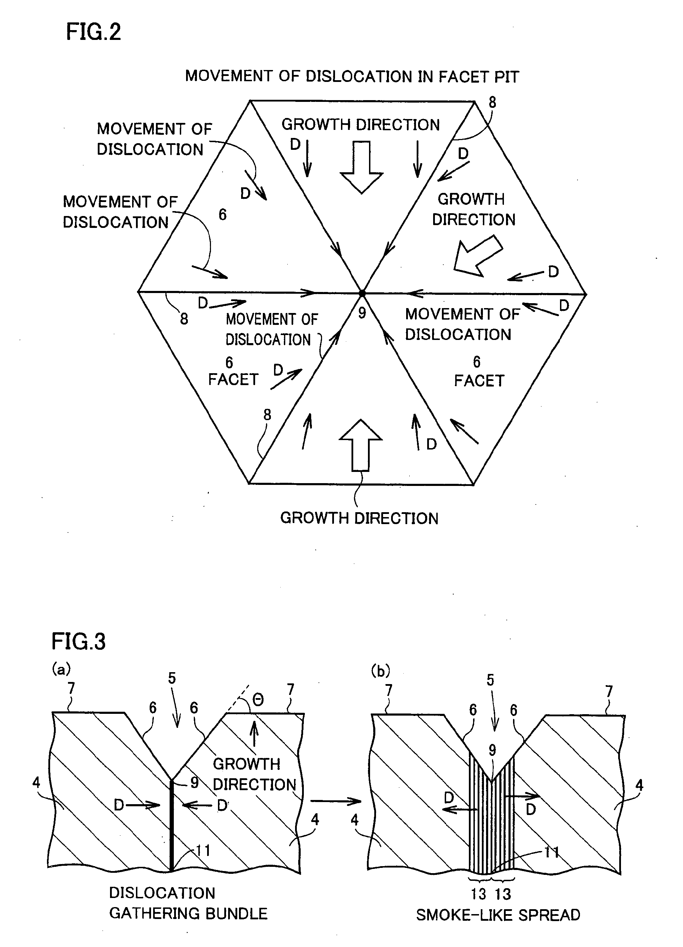

Fig. 2 is a pit plan view showing such dislocation reduction effect by facet growth. When facet 6 is maintained, the growth direction is the normal line direction, and dislocations D also extend in the normal direction. Fig. 2 shows that the direction of the dislocations and the growth direction are the same. Projecting on facets 6 in the plan view, the direction in which a dislocations D extend is the direction of the gradient of facet 6, which arrives at ridge 8. Arriving at ridge 8, dislocations D move toward inside along ridge 8. "Move toward inside" means that it relatively descends along ridge 8. Although dislocations D actually extend only laterally or slightly upwardly, they relatively descend because $v < u$, relative to the crystal growth surface. Dislocations D form a planar defect gathering portion 10 along ridge 8. Other dislocations D gather at a converge point 9 (pit bottom). Linear dislocation gathering bundle 11 continuous from pit bottom 9 is formed.

However, it has been found that this method in which facet growth is utilized involves the following problems (1) and (2).

(1) As the crystal is grown thicker and more dislocations D are gathered, dislocations D tend to be again dispersed and broadened in a smoke-like manner from dislocation gathering bundle 11 at the center of a pit constituted of facets. This is described referring to Fig. 3. Fig. 3(a) is a longitudinal cross-sectional view of a facet pit, which shows that dislocations D are gathered at pit bottom 9 to form linear dislocation gathering bundle 11 (linear defects). Fig. 3(b) shows that the once gathered dislocations D are again dispersed and broadened in a smoke-like manner 13. Smoke-like broadened dislocations 13 indicates that dislocation gathering bundle 11 continuous from pit bottom 9 is poor in confining dislocations D.

(2) Linear dislocation gathering bundle 11 at the center of pit 5 constituted of a plurality of facets is positioned accidentally. It is randomly distributed and cannot be determined in advance. That is, the position of dislocation gathering bundle 11 cannot be controlled.

Problem (2) is attributed to the fact that facet pit 5 is accidentally formed and that where to be formed cannot be determined. It is desirable that the position where pit 5 is formed can be determined in advance. As to Problem (1), it is desirable that a barrier or the like is formed, which is concrete and which does not release dislocations D once gathered.

To solve such two problems, the present inventors made the following developments. The present inventors considered that smoke-like broadened dislocations 13 as shown in Fig. 3(b) occurred because dislocations D gathered at bottom 9 of inverted hexagonal pyramid pit 5 were not eliminated but only resided there.

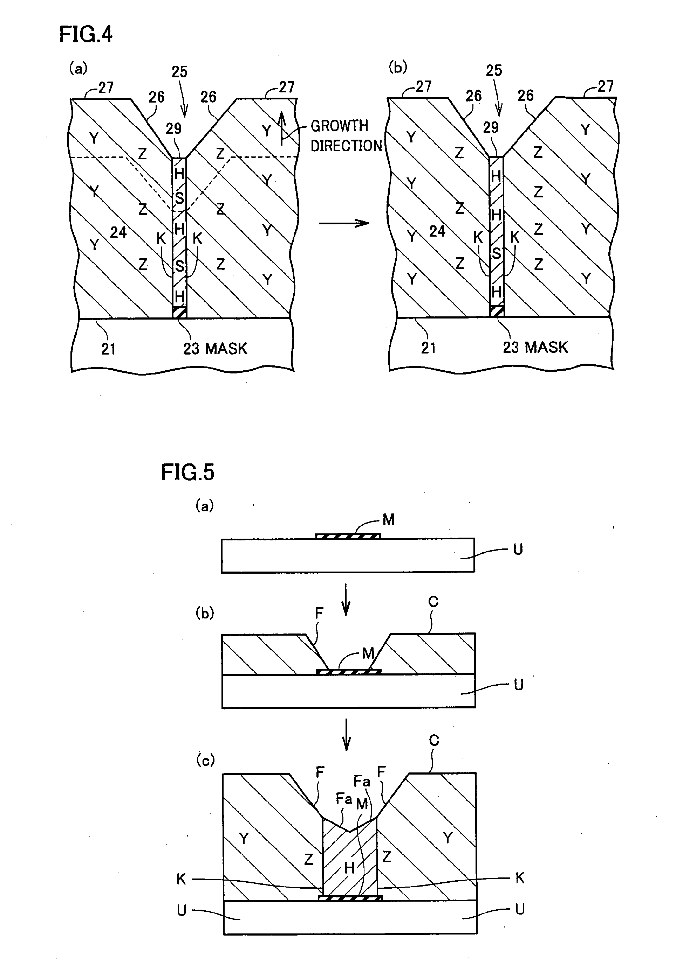

Then the inventors arrived at the idea of adding a dislocation D eliminating/accumulating mechanism to the dislocation D gathering portion. This is shown in Fig. 4(a) and (b). Isolated dot-like masks 23 having an effect of inhibiting epitaxial growth are applied on a ground substrate 21 so as to be regularly distributed. Growth occurs at the expose portion. At the center of an expose portion, growth in which C-plane is a top plane 27 occurs and leadingly proceeds. A crystal 24 is grown primarily at the expose portion.

However, growth hardly occurs on mask 23 having a wide width. Since growth proceeds at the expose portion, facets 26 the base of which is the mask end and facet pit 25 being the group of facets 26 are formed. The growth is continued until the end while facet pit 25 is unburied. Along facets 26, dislocations D are swept and arrive at pit bottom 29. Pit bottom 29 is positioned immediately over mask 23. Dislocations D converge at a portion over mask 23. The portion where dislocations converge is a crystal defect gathering region H. That is, in the grown gallium nitride crystal, a first crystal region formed over mask 23 is crystal defect gathering region H. This crystal defect gathering region H is constituted of a crystal grain boundary K and a core S, i.e., region H = core S + crystal grain boundary K.

By applying mask 23 on ground substrate 21, crystal defect gathering region H surrounded by crystal grain boundary K is produced as a dislocation D eliminating/accumulating mechanism. That is, mask 23, crystal defect gathering region H (first crystal region), and pit bottom 29 align on one line in the vertical direction. Mask 23 determines the positions of crystal defect gathering region H (first crystal region) and pit 25. In second crystal regions grown on the exposed portion on the ground substrate region in the grown gallium nitride crystal, a portion under facet 26 is referred to as a low crystal defect region portion Z, since crystal defects are reduced than in other portions. A portion under C-plane 27 on the expose portion is referred to as a C-plane growth region portion Y. As the second crystal regions are constituted of low crystal defect region portion Z and C-plane growth region portion Y, they are denoted by ZY in the following.

Dislocations D of the gallium nitride crystal converge at crystal defect gathering region H. Crystal defect gathering region H has a finite width, and moreover, surrounded by crystal grain boundary K. Dislocations D do not dispersed again from crystal defect gathering region H. Crystal grain boundary K has an effect of eliminating the dislocations. The inside of crystal grain boundary K is core S. Core S has an effect of accumulating and eliminating the dislocations. What is important is that the region that is constituted of crystal grain boundary K and core S where dislocations D converge is actively produced by mask 23. As the crystal growth progresses, while the state transits from Fig. 4(a) to Fig. 4(b), dislocations D are not dispersed again since they are confined in crystal defect gathering region H. The same state is maintained endlessly. Thus, confinement of dislocations D is fully achieved, solving the problem of the dislocations dispersed again in a smoke-like manner.

Initially, the nature of crystal defect gathering region H that is a first crystal region was not clear. Crystal defect gathering region H is not univocally determined. In one case, it may be a polycrystal region P. In another case, it may be a single crystal region A in which a crystal axis is slightly tilted relative to crystal regions (i.e., second crystal regions ZY, hereinafter the same applies) other than first crystal region. In such a case, it does not fully function as the dislocation D eliminating/accumulating mechanism. In still another case, there are no crystal defect gathering regions H at all, and facet 26 gradually grows over mask 23, resulting in a mere recess. In such a case also, it does not fully function as the dislocation D eliminating/accumulating mechanism. In still another case, it is a single crystal region J in which c-axis direction is reversed relative to second crystal regions ZY. It has been found that such diversity may depend on conditions for growth.

Optimally, crystal defect gathering region H being the first crystal region is formed over the entire mask 23 so as to be single crystal region J in which [0001] direction (c-axis direction) is reversed relative to second crystal regions ZY. In this case, in crystal defect gathering region H, crystal orientation is reversed with respect to c-axis direction relative to second crystal regions ZY, and therefore clear crystal grain boundary K is formed around crystal defect gathering region H. Crystal grain boundary K has a strong effect of eliminating and accumulating dislocations D. When crystal defect gathering region H is polycrystal region P, single crystal region A in which crystal orientation is slightly different from that of second crystal regions ZY, or a mere recess, crystal grain boundary K is not clearly formed and the effect of eliminating and accumulating dislocations D is weak.

There are two types of single crystal regions that are second crystal regions ZY. The portion grown under a facet is referred to as low crystal defect region portion Z. The portion grown under C-plane is referred to as C-plane growth region portion Y. They are both single crystals having the same crystal orientation and have a low density of dislocations. However, they are different in electric characteristics. C-plane growth region portion Y has a high resistance, while low crystal defect region portion Z has a low resistance.

While low crystal defect region portion Z and C-plane growth region portion Y are each a single crystal in which [0001] direction (c-axis direction) is upward, crystal defect gathering region H, being single crystal region J in which c-axis is reversed, is a single crystal in which [000-1] orientation (-c-axis direction) is upward. As the crystal orientation is reversed, crystal grain boundary K is stably produced between the boundary of H and Z. As crystal grain boundary K has the effect of eliminating and confining dislocations D, it is a useful characteristic that K is produced between crystal defect gathering region H and low crystal defect region portion Z. The inside and outside regions are clearly distinguished from each other at crystal grain boundary K.

The formation of region (referred to as orientation reversed region J, hereinafter the same applies) in which c-axis direction ([0001] direction) is reversed as crystal defect gathering region H is most effective in reducing a dislocation density. It is noted that "c-axis direction is reversed" means that c-axis direction is different by 180°. Orientation reversed region J is also referred to as polarity reversed region J, since the polarity in c-axis direction of the crystal is reversed because of the reversed crystal orientation of c-axis direction. That is, in the present specification, the orientation reversed region and the polarity reversed region are synonymous with each other. The inventors employs such naming because the crystal structure of GaN is wurtzite type, having the polarity only in c-axis direction. If c-axis is reversed, then the polarity is reversed as well.

When crystal defect gathering region H is polarity reversed region J, crystal defect gathering region H becomes a recess since the crystal growth rate of polarity reversed region J is low. It can be positioned at the pit bottom or a trough. Accordingly, crystal defect gathering region H can stably be present at the pit bottom of the inverted hexagonal pyramid where dislocations are gathered.

At crystal grain boundary K around crystal defect gathering region H, dislocations D are efficiently eliminated and the smoke-like broadened dislocations do not occur. A gallium nitride crystal of a low defect density in which the dislocations are confined in crystal defect gathering region H and in the very close vicinity thereof can be obtained.

The region where crystal defect gathering region H should occur can be fixed to an arbitrary position. This crystal defect gathering region H does not randomly accidentally occur and present, but instead it can be formed at a predetermined position. Thus, an excellent gallium nitride crystal can be produced, for example in which crystal defect gathering regions H are aligned regularly.

There may be various types as to the shape of crystal defect gathering region H. For example, it can be a dot-like isolated closed region. Japanese Patent Laying-Open No. 2003-165799 proposes a gallium nitride crystal having such an arrangement of crystal defect gathering region H.

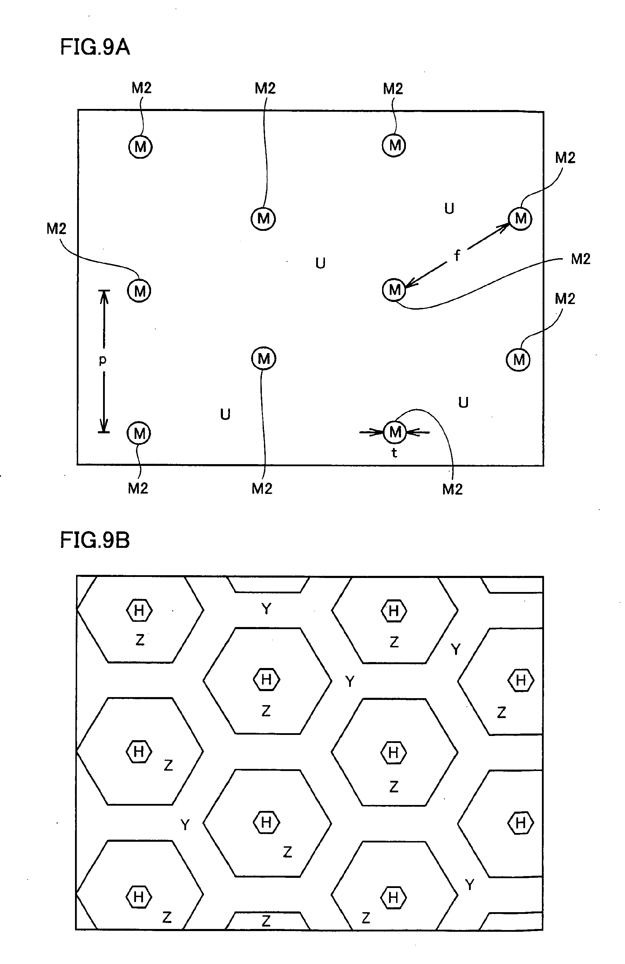

Fig. 9A is a plan view showing one example of the dot mask. Masks M of isolated dots regularly distributed on ground substrate U are formed. Over the expose portion, a crystal of a low defect density is formed. In the obtained crystal, the portion over each dot mask M is crystal defect gathering region H. A facet pit having this crystal defect gathering region H as a bottom is formed. The portion under the facet is low crystal defect region portion Z, and the portion under C-plane outside the facet is C-plane growth region portion Y.

Fig. 6B is a perspective view of a GaN crystal grown over ground substrate U provided with dot masks. While C-plane growth portion Y is great, there are a large number of pyramid pits constituted of facets F. Over a dot mask, a pit is formed.

Fig. 9B shows a planar structure, in which ground substrate U is removed from the GaN crystal grown over the dot mask, and the crystal is then ground and polished to be a flat substrate (wafer). The portion over the mask becomes crystal defect gathering region H, around which low crystal defect portion Z and C-plane growth region portion Y surround to form a concentric structure (YZH).

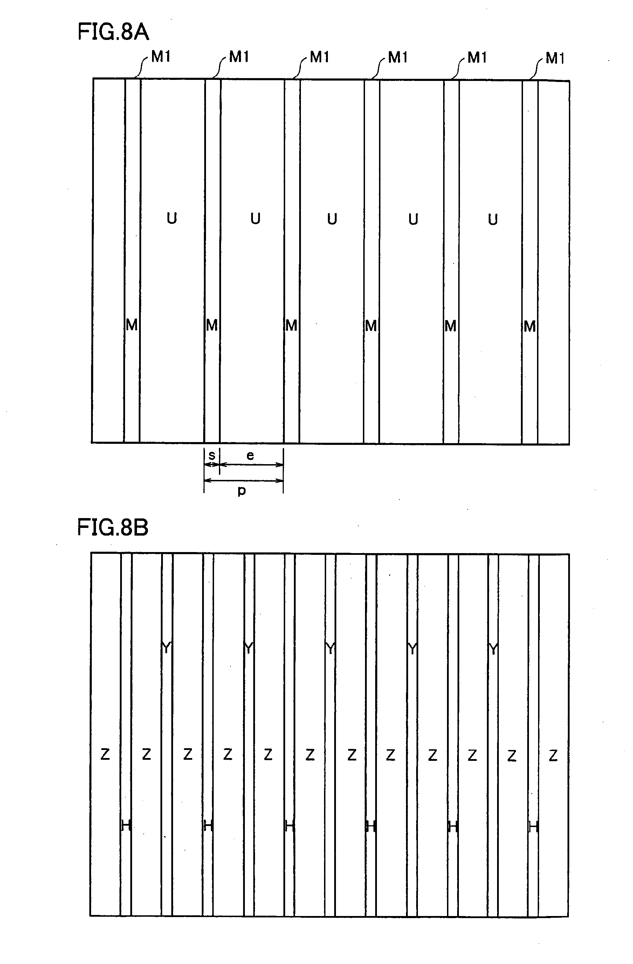

Alternatively, crystal defect gathering region H can be formed to be parallel strips (stripes). Japanese Patent Laying-Open No. 2003-183100 proposes a gallium nitride crystal having crystal defect gathering region H of such a stripe type. Stripe masks are shown in Fig. 8A. On ground substrate U, parallel and linear masks (width s) are regularly (pitch p) formed in a large number.

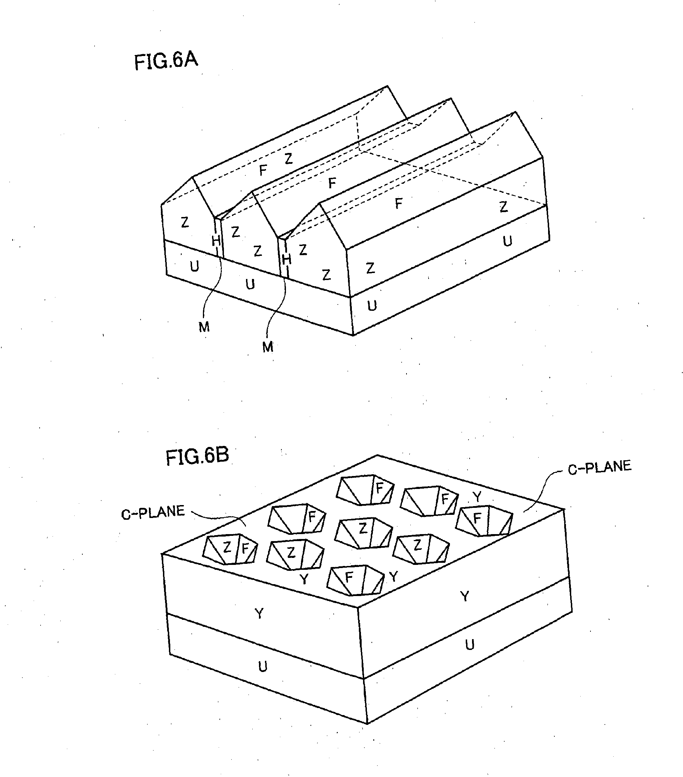

Fig. 6A shows a state in which a gallium nitride crystal is grown thereon. A crest formed of low crystal defect region portion Z is formed on an expose portion. A slope of the crest is facet F. Over mask M, a V-shaped groove formed of crystal defect gathering region H is formed. Fig. 8B shows a planar structure of a wafer, obtained by growing a gallium nitride crystal on ground substrate U on which the stripe masks are formed, then removing the crystal from ground substrate U, to be ground and polished. It has a parallel structure of HZYZHZYZ....

Fig. 5 is a drawing for describing the facet growth method using stripe masks. Masks M (stripe masks) extending in parallel with each other are applied on ground substrate U (Fig. 5(a)). Masks M extend perpendicularly to the surface of the drawing. A GaN crystal is grown through vapor phase deposition on ground substrate U and masks M. While a crystal nucleus is produced and grown on ground substrate U, a crystal nucleus is not formed on mask M and therefore crystal growth does not occur. In the portion other than mask M (expose portion), a GaN crystal is formed in c-axis direction (Fig. 5(b)). The top plane of the crystal is C-plane. Initially a crystal is not formed over mask M, and therefore a space is formed. Crystals from both sides approach the edge of the mask. The tilted plane of a crystal extending upwardly from the end of the mask is facet F.

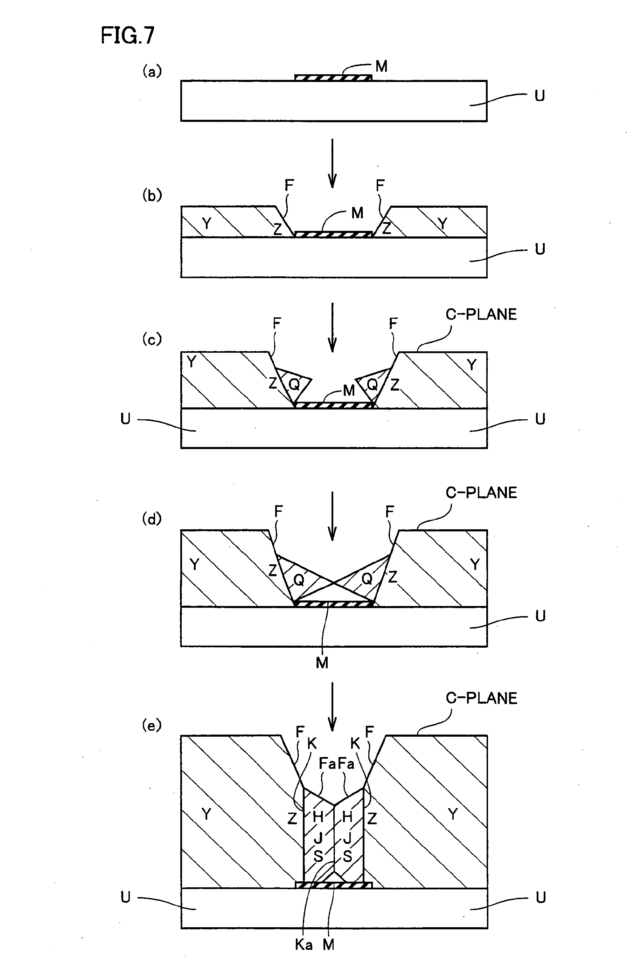

As the growth progresses further, the crystal grows also above mask M (Fig. 5(c)). This portion is a recess since the growth is delayed than in other portions. The crystal on mask M is crystal defect gathering region H in which c-axis direction ([0001] direction) is reversed relative to second crystal regions ZY. Another facets Fa, Fa with a smaller tilt are present thereon. They are identical to the tilt of the top plane of small polarity reversed crystal Q shown in Fig. 7 (c) and (d). Grown over the expose portion and under facet F is low crystal defect region portion Z. Grown over the expose portion and under C-plane (top plane) is C-plane growth region portion Y. The boundary between crystal defect gathering region H and low crystal defect region portion Z is crystal grain boundary K. The boundary line between differently tilted facet F and facet Fa is grain boundary K.

Since there are a plurality of parallel masks M, crystal defect gathering regions H form parallel troughs. A portion between masks M is low crystal defect region portion Z or C-plane growth region portion Y. Z and Y are parallel crests. That is, when the stripe masks are used, the crystal has a structure in which parallel crests and troughs are repeated. When there is no C-plane growth region portion Y, a sharp crest appears. When there is C-plane growth region portion Y, the portion becomes a flat crest.

A substantially similar manner is shown also when masks M are isolated dot masks. In this case, isolated pits each constituted of facets F around mask M is formed. The portion on the expose portion and under facet F is low crystal defect region portion Z, and the portion on the expose portion and under C-plane is C-plane growth region portion Y. It is noted that Z and Y are single crystal regions having a low density of dislocations, with the same crystal orientation. That is, a crystal has a structure in which a large number of pits are aligned on C-plane. While the states are similarly shown in the cross-sectional views, in the case of the dot masks, crystal defect gathering region H is an isolated closed region. Facet F often has plane orientation of {11-22}, {1-101} or the like. It can be said that mask M is the seed of crystal defect gathering region H.

The portion over the mask is crystal defect gathering region H. Crystal defect gathering region H is polycrystal region P, single crystal region A in which crystal orientation is displaced relative to other regions (second crystal regions ZY), or an orientation reversed single crystal region (polarity reversed region J) in which c-axis direction ([0001] direction) is reversed relative to other regions (second crystal regions ZY). There is also a case where crystal defect gathering region H is not formed over the mask (O). That is, there are four types of crystal region grown over the mask, which are O, A, P and J.

When crystal defect gathering region H that is the first crystal region is single crystal region J in which c-axis direction is reversed relative to second crystal regions ZY, Ga plane and N plane of crystal defect gathering region H are opposite to those of second crystal regions ZY. The present inventors habitually call orientation reversed single crystal region J having reversed c-axis direction as a "polarity reversed region". A compound semiconductor is generally a polarity crystal, and a GaN crystal having the crystal structure of wurtzite type has in c-axis direction Ga atom layers and N atom layers alternately overlapped with different intervals. Accordingly, it is a crystal having polarity in c-axis direction. Orientation reversed single crystal region J that is the first crystal region of GaN crystal has its c-axis direction reversed relative to second crystal regions ZY by 180°, and therefore it is called as "polarity reversed region".

The boundary between crystal defect gathering region H and low crystal defect region portion Z is crystal grain boundary K. The top of crystal defect gathering region H is facet Fa that is more moderately tilted.

By forming initially the seed (mask) on the ground substrate, the position where crystal defect gathering region H (first crystal region) is formed is determined. Correspondingly, the positions where low crystal defect region portion Z and C-plane growth region portion Y (second crystal regions ZY) are formed are also determined. This means that the aforementioned drawback that the position of crystal defect gathering region H cannot be determined has been overcome.

Moreover, since orientation reversed crystal defect gathering region H has clear crystal grain boundary K around it, dislocations once converged do not dispersed again in a smoke-like manner. By forming the mask on the ground substrate in advance, it becomes possible to control the position where crystal defect gathering region H is formed.

While the positioning control of H, Z and Y structures can clearly be achieved by the mask position, it has been found that there are cases where crystal defect gathering region H is capable of forming clear crystal grain boundary K and where it is not. While crystal defect gathering region H being the first crystal region is formed over the mask, it is not always orientation reversed region (polarity reversed region) J in which c-axis direction is rotated by 180°. Instead, it may be polycrystal region P. It may be single crystal region A in which crystal orientation is different from that of second crystal regions ZY. Crystal defect gathering region H may not be formed (O). There are four types of the crystal region grown over the mask, which are O, A, P and J.

When crystal defect gathering region H that is the first crystal region formed over the mask is polycrystal region P, there is also a partial crystal of which orientation is similar to low crystal defect region portion Z adjacent thereto. Therefore, there are no discrepancy in the crystal structure between them, and hence crystal grain boundary K does not clearly appear. Also, when crystal defect gathering region H is single crystal region A in which c-axis direction is slightly tilted relative to second crystal regions ZY, the crystal structures are partially similar and crystal grain boundary K is not clear. Crystal grain boundary K clearly appears when crystal defect gathering region H is polarity reversed region J in which c-axis direction is reversed by 180° relative to second crystal regions ZY. When polarity reversed region J is formed, in any portion crystal defect gathering region H and surrounding low crystal defect region portion Z are greatly different in the lattice structure. Thus, the boundary becomes crystal grain boundary K.

Without crystal grain boundary K, the effect of capturing, eliminating and accumulating dislocations is weak. Therefore, it is strongly desired that crystal defect gathering region H in which crystal orientation is reversed is always formed over the mask as the first crystal region. Japanese Patent Laying-Open No. 2006-66496 discloses crystal growth in which a crystal defect gathering region H, in which polarity is different from that of other crystal region, is formed over a mask. However, it does not disclose a method of constantly forming a polarity reversed region as crystal defect region H, or a condition therefor. An object of the present invention is to provide a sure crystal growth method that causes crystal defect gathering region H formed over the mask to be polarity reversed region J in which c-axis direction ([0001] direction) is reversed by 180° relative to second crystal regions ZY, and a crystal growth condition therefor.

SUMMARY OF THE INVENTION

It is optimum that polarity reversed region J is formed over the entire mask as crystal defect gathering region H being the first crystal region. If a crystal having small polarity reversed region J as crystal defect gathering region H is produced, dislocations are again released from the locations where crystal regions other than the polarity reversed region (for example single crystal region A in which crystal orientation is displaced relative to second crystal regions ZY) are formed. If for example blue-violet laser is produced using a GaN substrate manufactured from such a crystal, laser yield will be significantly poor. In order to obtain a crystal that serves as a useful substrate, an object of the present invention is to ensure formation of polarity reversed region J over the mask. A close observation was carried out as to the manner of crystal growth when polarity reversed region J in which c-axis direction was reversed by 180° relative to second crystal regions ZY was formed over the mask. It was found that polarity reversed region J in which c-axis direction was reversed was formed over the mask through the following processes. Fig. 7 shows such processes.

1) A seed (mask) M using a material inhibiting epitaxial growth is formed at the position where crystal defect gathering region H is to be formed on ground substrate U. A seed means the seed for crystal defect gathering region H, and it is synonymously used as mask M. Fig. 7(a) shows this state. While only one stripe mask M is shown, actually a plurality of masks M are formed in parallel to one another.

2) On ground substrate U, a gallium nitride crystal is grown through vapor phase deposition. Since crystal nucleus is easily formed on ground substrate U (expose portion) and not easily formed over the mask (cover portion), the crystal growth is initiated from the expose portion. The crystal orientation in which C-plane is the top plane is attained. The progress of the growth of the gallium nitride crystal is stopped at the end (periphery) of the seed (mask). Initially, the crystal does not climb on seed M. It does not climb on seed M and does not grow laterally. A tilted plane is generated, which extends diagonally upward from the periphery of the seed (mask) to the expose portion side (Fig. 7(b)). This is one of facets F that are not C-plane. Often, this facet F is {11-22} plane. When the stripe mask is seed M, facet F extends in the direction perpendicular to the surface of the drawing. When it is the dot mask (isolated dot), it is an opening (pit). Since the manner is similar between the stripe and dot masks, herein the case of the stripe mask is described.

3) From an end (an end on the mask periphery side) of a tilted plane of a facet of the gallium nitride crystal of which growth is stopped at the end (periphery) of the seed (mask), a fine crystal Q forming first crystal region H is produced and extends in the horizontal direction (Fig. 7(c)). This crystal is a polarity reversed crystal Q in which c-axis direction ([0001] direction) is reversed by 180° relative to other crystal regions (second crystal regions ZY). Polarity reversed crystal Q has a plane tilted more moderately than facet F, and has underneath another tilted plane. As will be described in the following, polarity reversed crystal Q increases in size to form polarity reversed region J.

4) As the crystal grows, the number of polarity reversed crystals Q generated on facets F increases. Each of polarity reversed crystals Q grows and becomes a long column above each side of mask M. From opposing sides of mask M, polarity reversed crystals Q extend so as to cover mask M (Fig. 7(c)).

5) Polarity reversed crystals Q each have facet Fa having a smaller angle than facet F has, on the upper side. Upper facet Fa is a facet with a small tilt angle, which has plane orientation such as {11-2-6}, {11-2-5} or the like. The lower facet is a more greatly tilted plane.

6) Polarity reversed crystals Q are enlarged in the vertical and horizontal directions, and tips of polarity reversed crystals Q collide and contact with each other over mask M. Polarity reversed crystals Q are integrated to form a bridge portion as shown in Fig. 7(d). After the bridge portion is formed, a crystal in which c-axis direction ([0001] direction) is similarly reversed by 180°C relative to second crystal regions ZY is grown on polarity reversed crystals Q, Q (hereinafter, the crystal is also referred to as a orientation reversed crystal). A crystal is also formed in the gap below, in which orientation is also similarly reversed. This portion immediately over mask M is not formed by the crystal that climbs on mask M and extends laterally, but instead, it is formed by the crystal grown downwardly from the bridge portion where polarity reversed crystals Q are integrated. The growth direction is opposite to the crystal growth direction of second crystal regions ZY.

7) The portions where polarity reversed crystals Q, Q has collided are grown thickly, maintaining lattice mismatched boundary Ka between them. This boundary Ka is different from crystal grain boundary K between polarity reversed crystal Q and adjacent low defect single crystal region Z. Polarity reversed crystal Q becomes crystal defect gathering region H.

8) By thickly growing the crystal (Fig. 7(e)), dislocations in the gallium nitride crystal is gathered into crystal defect gathering region H over mask M by the growth of the tilted plane of facet F. The gathered dislocations are partially eliminated and reduced at crystal grain boundary K that is the boundary between crystal defect gathering region H (polarity reversed crystal Q) and low defect single crystal regions Z, or at core S. Polarity reversed crystal Q extends upwardly, whereby crystal defect gathering region H is formed. The dislocations not being eliminated are captured and accumulated inside crystal grain boundary K and core S. Under facet F, dislocations are reduced to form low defect single crystal regions Z.

Through such processes, crystal defect gathering region H as orientation reversed region (polarity reversed region) J is formed. Therefore, in order for the portion over mask M to be a c-axis reversed portion relative to second crystal regions ZY, it is optimum to form polarity reversed crystal Q as shown in Fig. 7(c) on the entire plane of a facet (for example {11-22} plane). Also, it is necessary to form stably. If polarity reversed crystal Q cannot stably be formed on facet F, crystal defect gathering region H over mask M cannot become the desired orientation reversed region. In this case, dislocations in the surrounding region (second crystal region) cannot be attracted and eliminated. The dislocations will be spread and low defect single crystal region portion Z will not be formed.

When mask M is simply formed on ground substrate U and a crystal is grown through vapor phase deposition, the portion over mask M will not successfully become orientation reversed region J. It is not easy to stably form polarity reversed crystals Q in which crystal orientation is reversed on the entire plane of facet F extending diagonally from the mask edge. A crystal growth condition for reversing the intended crystal orientation has never been disclosed as to the growth of any crystals, not being limited to a GaN crystal or a compound semiconductor crystal.

The present invention is directed to reduction of dislocations by facet growth, which can be called as the facet growth method. It is clearly different from known ELO (Epitaxial Lateral Overgrowth) method, which is a scheme of reducing dislocations by using mask M. Although it is clearly different, sometimes the scheme of the present invention is confused with the ELO method because it is a scheme in which mask M is used to reduce dislocations. In order to avoid such confusion, some of the differences are described herein.

(a) In the ELO method, the cover portion area is far greater than the expose portion area (cover portion > expose portion). It can be recognized that a mask has openings at several portions. In the facet growth method according to the present invention, the expose portion is great and the cover portion is small (cover portion < expose portion). It can be recognized that the ground substrate is provided with only a few masks.

(b) They are clearly different in the presence of an orientation reversed region (polarity reversed region) of a crystal at the end of the cover portion. In the ELO method, the crystals produced at the expose portion maintains the orientation and climbs on the mask . That is, the crystal orientation is maintained. It is in the same crystal orientation. For example, when {11-22} facet is present at the mask end, the crystal climbs on the cover portion while the plane and the tilt are maintained. Over the mask also, the growth is continued while {11-22} plane is maintained. Therefore, the orientation reversion (polarity reversion) at the boundary of the mask does not occur. In the facet growth method according to the present invention, the crystal produced at the expose portion does not climb on the mask as it is. Instead, polarity reversed crystal Q is produced in the middle of facet distanced from the cover portion, which therefore is not continuous with the expose portion crystal.

(c) In the ELO method, the crystal growth direction for reducing dislocations is the lateral direction. By allowing a crystal to grow horizontally and laterally to the mask, threading dislocations in the portion laterally grown are reduced. However, in the facet growth method according to the present invention, the direction of crystal growth is the thickness direction. By allowing a crystal to grow in the thickness direction, dislocations are gathered into crystal defect gathering region H and reduced. They are different in the crystal growth direction.

(d) As to the process of reducing dislocations, according to the ELO method, a low density of dislocations is attained over the mask. A defect region of a high dislocation density is formed at the expose portion. In contrast, according to the facet growth method, a single crystal of excellent quality with a low dislocation density is formed at the expose portion. A region with many defects and with a high dislocation density is formed over the mask. The ELO method and the facet growth method are totally opposite as to at which portion, i.e., at the cover portion or at the expose portion, the low dislocation density region and the high dislocation density region are formed.

In the present invention, masks inhibiting epitaxial growth are partially formed on the ground substrate, to produce a ground substrate surface where an expose portion and a cover portion are both present. A gallium nitride crystal is grown through vapor phase deposition on the ground substrate. Here, the present invention additionally includes a process of generating polarity reversed region (orientation reversed region) J on the mask. The vapor phase deposition growth of a gallium nitride crystal has been the buffer layer formation and the epitaxial growth. Between them, the present invention additionally includes the process of polarity reversed region formation. That is, the growth is constituted of three stages of the buffer layer formation, the reversed region formation, and the epitaxial growth.

As the ground substrate, a sapphire (0001) single crystal substrate (a sapphire single crystal substrate in which the surface on which a gallium nitride crystal is grown is (0001) plane), a Si (111) single crystal substrate (a Si single crystal substrate in which the surface on which a gallium nitride crystal is grown is (111) plane), a SiC (0001) single crystal substrate (a SiC single crystal substrate in which the surface on which a gallium nitride crystal is grown is (0001) plane), a GaN single crystal substrate, a GaAs (111) A-plain single crystal substrate (a GaAs single crystal substrate in which the surface on which a gallium nitride crystal grown is (111) A-plane) or the like can be employed. A complex substrate (also referred to as a template) in which a GaN thin film is grown on a sapphire substrate can also be employed as the ground substrate.

A mask is formed on a ground substrate (Fig. 7(a)). A mask material is $SiO_2$, Pt, W, SiON, SiN or the like. Other material can possibly be employed as a mask material. It is only necessary for the material to have thermochemical stability under the growth condition of vapor phase deposition, and to be capable of inhibiting epitaxial growth of a gallium nitride crystal. The thickness is about 30nm - 300nm. An exemplary mask pattern may be the stripe type (M1) in which a plurality of lines parallel with each other are aligned with a constant pitch (Fig. 8A). Alternatively, it may be the dot type (M2) in which isolated dots are regularly dispersed (Fig. 9A). Application of the mask forms the cover portion and the expose portion on the ground substrate surface. Preferably the cover portion is small and the expose portion is great.

It is also possible to form, in the expose portion, linear or lattice-like fine masks with some $\mu$m width and with some $\mu$m pitch using the conventional ELO method or HELO method. In the expose portion where the fine masks are formed, a crystal climbs on the mask laterally while maintaining the orientation, and therefore no polarity reversion occurs. Although threading dislocations in this portion are somewhat reduced, this portion can still be regarded as the expose portion in the present invention since the orientation is maintained.

On the ground substrate provided with the mask, a gallium nitride crystal is grown at a low temperature to form a thin buffer layer of about 30 nm - 200 nm. The buffer layer forming temperature is expressed as Tb. A low temperature such as Tb = 400 C° - 600 C° is preferable. The buffer layer has the effect of relaxing the stress of the ground substrate and the gallium nitride crystal.

In the present invention, the next crystal growth for generating a polarity reversed region (orientation reversed region) is referred to as a first growth. The essence of the present invention lies in the growth condition of the first growth. In the first growth of a gallium nitride crystal, crystal growth proceeds from the expose portion, and a portion contacting the cover portion (mask) becomes facet F. In the middle of facet F rising from an end of cover portion, fine polarity reversed crystal Q is produced. Polarity reversed crystal Q has its orientation 180° reversed relative to surrounding single crystals. Polarity reversed crystals Q extend from opposing sides of the cover portion (mask) and are integrated. Crystal grows further on polarity reversed crystal Q, whereby polarity reversed crystal Q is enlarged. This accumulates and crystal is also produced over the cover portion. Since the crystal grown over the cover portion is what formed on polarity reversed crystal Q, its c-axis direction is different from that of second crystal regions ZY by 180°. This polarity reversed region J extends upwardly over the cover portion, while substantially maintaining the cross sectional area of the cover portion (slightly narrower than the width of the cover portion) (Fig. 7(e)). This polarity reversed region J is crystal defect gathering region H that attracts dislocations from crystals of the surrounding region (i.e., second crystal regions ZY) and allows the dislocations to converge.

Since dislocations converge to the portion over the mask, this portion is referred to as crystal defect gathering region H. Crystal defect gathering region H is one of the three of polycrystal region P, single crystal region A in which a crystal axis is tilted relative to other regions (note that c-axis direction ([0001] direction) is not completely reversed), and single crystal region (polarity reversed region) J in which c-axis direction is reversed relative to other regions. In some cases crystal defect gathering region H is not formed (O).

Particularly, it is the feature of the present invention that the first crystal region grown over the mask is polarity reversed region J. Crystal defect gathering region H pulls out dislocations from surrounding crystals grown over the adjacent expose portion and under the facet, and confines them in crystal defect gathering region H. The crystals grown over the expose portion and under the facet become single crystal Z with a low dislocation density. Polarity reversed region J have the strongest such effect among others.

In the present invention, conditions for causing crystal defect gathering region H to be polarity reversed region J have been sought for, and obtained. The present invention has enabled to produce polarity reversed region J always over the mask.

Which of the three, i.e., single crystal region A in which the crystal axis is tilted, polycrystal region P, and polarity reversed region J, the first crystal region over the mask is can be determined by cathode luminescence (CL). It can also be known by fluorescent microscope observation. GaN crystals are uniformly substantially transparent and therefore cannot be determined by the naked eye.

It has been found that, in order to stably grow crystal defect gathering region H that is polarity reversed region J in which c-axis direction ([0001] direction) is reversed relative to other regions (second crystal regions ZY), the crystal growth conditions of the initial formation stage of crystal defect gathering region H are important. If the initial crystal growth conditions are not successfully met, crystal defect gathering region H grown over the mask does not become polarity reversed region J, and instead becomes polycrystal region P or single crystal A in which a crystal axis is tilted (note that c-axis direction is not reversed). Alternatively, facet F gradually covers over the mask. This results in a mere recess. With polycrystal region P, single crystal A in which a crystal axis is tilted, or the recess, the effect of attracting dislocations from adjacent regions thereto (that is, the second crystal regions) to thereby reduce dislocations in the adjacent region, to eliminate the dislocations, and to continuously confine dislocations that are not eliminated, is insufficient. It is strongly desired that crystal defect gathering region H over the mask becomes polarity reversed region J.

In the above-described processes, 3), 4), 5) and 6) correspond to the initial stage of polarity reversed region J (fine polarity reversed crystal Q) formation. Generation of polarity reversed crystal Q is important. The present invention clarifies conditions for generating polarity reversed crystal Q and the subsequent polarity reversed region J. That is, the present invention clarifies how the growth temperature, growth rate, ground substrate, masks and the like should be.

Here, the crystal growth for generating polarity reversed crystal Q and polarity reversed region J is referred to as "first growth". The growth temperature for generating polarity reversed region J is referred to as "first growth temperature" Tj (°C). Once fine polarity reversed crystal Q and polarity reversed region J are formed, thereafter normal epitaxial growth is performed so that a thick crystal is obtained. The growth time for generating polarity reversed region J may be short and may be about 0.25 - 2 hours, although it depends on the growth rate.

The present inventors have conducted many experiments, and as a result have found that the first growth temperature Tj = 900°C - 990°C causes polarity reversed region J to be generated on the entire mask M, and low crystal defect region portion Z can be produced in the entire crystal. This temperature range has conventionally been considered to be inappropriate for the vapor phase deposition of gallium nitride. Generally, it has been regarded that higher temperature allows a crystal of higher quality to grow. It has been common sense to carry out the vapor phase deposition of gallium nitride at 1000°C or higher. However, it was found for the first time that, in order for polarity reversed region J, which is the essence of the present invention, to be surely generated over the entire mask, the growth condition of relatively low temperature of 900°C - 990°C was appropriate.

The present inventors have also found that, when the first growth temperature Tj = 920°C - 960°C, at each growth temperature polarity reversed region J could be generated over the entire mask M, even with different first growth rates Vj. This allows polarity reversed region J and low crystal defect region portion Z to be more stably generated, and hence it is further desirable for industrial manufacturing of gallium nitride crystals.

Further, the present inventors have conducted in an organized manner many experiments in which growth rate was varied for each growth temperature included in, and exceeding, the above-specified temperature range. As a result, they have found that the first growth condition that allowed polarity reversed region J to be generated strongly depended also on first growth rate Vj (µm/h) at each first growth temperature Tj (°C). First growth temperature Tj and first growth rate Vj synergize. Then, they have found that the growth condition appropriate for allowing polarity reversed region J to be generated was the condition range expressed by the following expression (i) with Tj and Vj:

$$[-439 \times \{1000 / (Tj + 273.15)\} + 387] < Vj < [-736 \times \{1000 / (Tj + 273.15)\} + 737] \quad \ldots\ldots (i)$$

Expressing Tj (°C) by absolute temperature T (K), the above expression (i) can be expressed by the following expression (ii):

$$(-4.39 \times 10^5 / T + 3.87 \times 10^2) < Vj < (-7.36 \times 10^5 / T + 7.37 \times 10^2) \quad \ldots\ldots (ii)$$

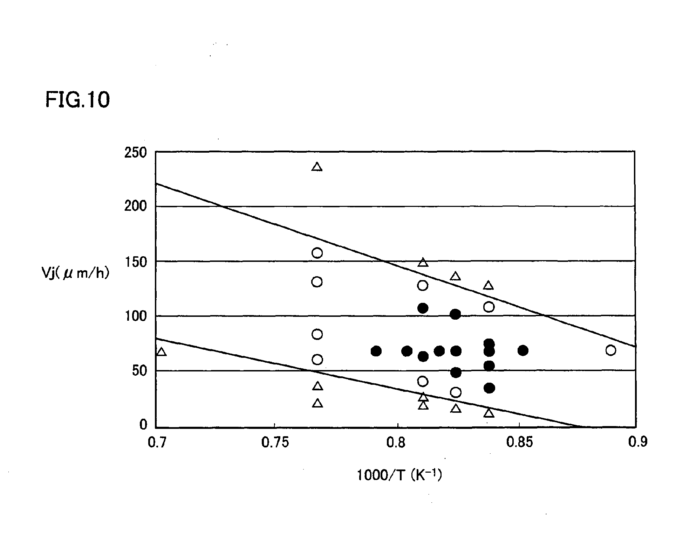

Expression (ii) shows the growth condition in a range surrounded by two solid lines in Fig. 10.

As shown in Fig. 10, even with the first growth temperature exceeding the 900°C - 990°C range, polarity reversed region J is easily generated over mask M if it is within the growth condition range expressed by expression (ii). The fact, that the growth temperature and the growth rate synergize to allow polarity reversed region J to be easily generated, has been discovered by the present inventors for the first time.

It is most desirable that polarity reversed region J is formed over the entire mask M under the foregoing first growth condition, since a low density of dislocations is surely attained in low crystal defect region portion Z around each polarity reversed region J. It is noted that, even when polarity reversed region J is not present over mask M in the entire region of crystal, and it is partially disconnected or partially not generated, a useful GaN crystal can be produced. This is because, when polarity reversed regions J are generated over most part of mask M, there is the function of gathering dislocations at the generated polarity reversed regions J to confine and eliminate them. Accordingly, low defect single crystal region portion Z is still formed in most part of the crystal, whereby the dislocation density in the crystal is significantly reduced.

The ratio obtained by dividing $NH_3$ partial pressure $P_{NH3}$ by HCl partial pressure $P_{HCl}$ in the first growth of gallium nitride crystal should appropriately be $P_{NH3} / P_{HCl}$ = 3-50. Also, 0.05 atm (5kPa) $\leq P_{NH3} \leq$ 0.3 atm (30kPa) is appropriate.

The first growth of a gallium nitride crystal is about 0.25-2 hours. Over the mask, crystal defect gathering region H of polarity reversed region J is formed, while low crystal defect region portion Z is formed above the expose portion. In some cases, C-plane growth region portion Y is formed at the central portion of the expose portion. In some cases, C-plane growth region portion Y is not formed.

Epitaxial growth is carried out in order to thicken the crystal thereafter. The growth for thickening the crystal is referred to as "the second growth". The growth time may range from some tens of hours, some hundreds of hours, to some thousands of hours, depending on the intended thickness of the crystal. The epitaxial growth temperature for thickening the crystal is identified as second growth temperature Te. Epitaxial growth temperature Te for the thick film growth is preferably at least 990 °C, and more preferably Te = 1000 °C - 1200 °C.

A gallium nitride substrate of a low dislocation density and of high quality is strongly requested. The present invention clarifies the conditions that allows polarity reversed region J to be generated over the mask in the facet growth method, in which: mask M is formed on ground substrate U; crystal growth is performed while facet F is maintained; polarity reversed region J is formed over the mask; and defects are gathered at polarity reversed region J, whereby dislocations in the crystal at the expose portion is reduced. The present invention clarifies the conditions for forming polarity reversed region J, whereby stable polarity reversed region J is formed over the mask and dislocations of the single crystal portion on the expose portion can further be reduced so that a gallium nitride crystal of high quality can be grown.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a perspective view of a pit portion, for showing that, in the facet growth method proposed by the present inventors in WO99/23693, when growth is allowed without burying a hexagonal pyramid pit constituted of facet planes, dislocations extend in the facet normal line direction and gather at a boundary as the growth progresses, to further converge at a bottom of the pit along the boundary. Fig. 1(a) shows an initial stage of the growth and Fig. 1(b) shows a progressed stage of the growth.

Fig. 2 is a plan view of a pit portion, for showing that, in the facet growth method proposed by the present inventors in WO99/23693, when growth is allowed without burying a hexagonal pyramid pit constituted of facet planes, dislocations extend in the facet normal line direction and gather at a boundary as the growth progresses, to further converge at a bottom of the pit along the boundary. As the growth progresses at the facet in the normal line direction, dislocations also progress in that direction.

Fig. 3 is a cross-sectional view of a facet pit portion, for showing that, in the facet growth method proposed by the present inventors in WO99/23693, a bundle of dislocations once gathered at the bottom of the pit again spreads in a smoke-like manner. Fig. 3(a) shows a state where dislocations are once gathered at the pit bottom to form a dislocation gathered bundle, and Fig. 3(b) shows a manner of the dislocations being separated from the pit bottom and spread in a smoke-like manner.

Fig. 4 is a longitudinal cross-sectional view of a pit and a V-shaped groove, for showing that, in the facet growth method using a mask proposed by the present inventors in Japanese Patent Laying-Open No. 2001-102307 and Japanese Patent Laying-Open No. 2003-165799, a crystal defect gathering region H having an effect of confining dislocations is produced over the mask and that dislocations once captured will not be dispersed and the growth is continued as it is. Fig. 4(a) shows a manner in which dislocations converge to defect gathering region H over the mask by the facet growth, and Fig. 4(b) shows a manner in which the dislocations are confined in defect gathering region H even when the facet growth further progresses.

Fig. 5 is a longitudinal cross-sectional view showing the facet growth method in which a mask is applied on a ground substrate and a gallium nitride crystal is grown thereon. Fig. 5(a) shows a state where the mask is formed on the ground substrate. Fig. 5(b) shows a manner in which, when the gallium nitride crystal is grown, the crystal is grown only at the expose portion and no crystal growth occurs over the mask, and a facet diagonally extending from a mask end occurs. Fig. 5(c) shows a manner in which, as the crystal growth further progresses, the crystal grows also over the mask to form two-stages of facets.

Fig. 6A is a perspective view showing a gallium nitride crystal grown through the facet growth method on the ground substrate to which stripe masks are applied.

Fig. 6B is a perspective view showing a gallium nitride crystal grown through the facet growth method on the ground substrate to which dot masks are applied.

Fig. 7 is a longitudinal cross-sectional view related to the description of conditions for crystal defect gathering region H to be a polarity reversed region, when crystal defect gathering region H is formed over the mask at the initial stage of the growth. Fig. 7(a) shows a state in which the mask is provided on the ground substrate. Fig. 7(b) shows a manner in which, in the vapor phase deposition growth of the gallium nitride crystal, crystal growth occurs at the expose portion and the crystal growth does not occur over the mask, and facets of which ends are the mask are produced. Fig. 7(c) shows a state where polarity reversed crystals are produced at the facets. Fig. 7(d) shows a state where the polarity reversed crystals are integrated over the mask. Fig. 7(e) shows a manner in which crystal having the same crystal orientation as the polarity reversed crystals is grown over the polarity reversed crystals.

Fig. 8A is a plan view showing a substrate in which masks being parallel with each other are formed with a constant pitch on a ground substrate.

Fig. 8B is a plan view showing a CL image of a wafer obtained by growing a crystal on the substrate shown in Fig. 8A through the facet growth method, separating the grown crystal from the ground substrate, subjecting it to grinding and polishing to be a flat plate.

Fig. 9A is a plan view showing a substrate in which, isolated dot-like masks are formed on a ground substrate with a constant pitch so as to attain sixfold symmetry.

Fig. 9B is a plan view showing a CL image of a wafer obtained by growing a crystal on the substrate shown in Fig. 9A through the facet growth method, separating the grown crystal from the ground substrate, subjecting it to grinding and polishing to be a flat plate.

Fig. 10 is a graph showing the relationship between a first growth condtion and generation of a polarity reversed region in the gallium nitride crystal growth method according to the present invention. In the graph, the ordinate indicates the growth rate Vj ($\mu$m/h) and the abscissa indicates $1000/T(K^{-1})$ which is reciprocal of growth temperature T in absolute temperature multiplied by 1000. In the graph, solid circles represent that the polarity reversed regions are generated over the entire mask, open circles represent that the polarity reversed regions are generated over most of the mask, and triangles represent that the polarity reversed regions are slightly generated over the mask.

DESCRIPTION OF THE PREFERRED EMBODIMENTS

As a vapor phase deposition growth method of a gallium nitride crystal, the Hydride Vapor Phase Epitaxy (HVPE) method, the Metal Organic Chemical Vapor Deposition (MOCVD) method, the Metal Organic Chloride (MOC) method, the sublimation method and the like may be employed. The conditions with which a polarity reversed region is generated were sought for in the HVPE method, since the HVPE method achieves the fastest growth rate among others and an excellent material yield, allowing a GaN crystal to grow at low costs at the current stage, although recently even the MOCVD method can provide growth of which rate exceeds 50 $\mu$m/h and therefore other vapor deposition methods such as the MOCVD method may be capable of achieving similar crystal growth.

Recently, it is reported that the GaN crystal producing method through the liquid phase growth method such as the flux method attains the growth rate of 40 $\mu$m/h, although the diameter is small. However, the liquid phase growth method is the growth from a state that is close to a thermochemical equilibrium state, its growth principle itself being different from that of the vapor phase deposition. Therefore, conditions may greatly differ, and the present invention is not applicable to the liquid phase growth method.

Accordingly, in the Examples, what is grown through the HVPE method will be described. In the HVPE method, a lateral hot-wall type reactor (HVPE reactor) is employed. The HVPE reactor has a heater divided in the lateral direction around it, and it is capable of forming temperature distribution freely in the lateral direction. On the upstream side in the space inside the reactor, the HVPE reactor has a Ga metal boat in which Ga metal is placed. On the downstream side, the HVPE reactor has a susceptor on which a sample is to be placed.

In the HVPE reactor, crystal growth is usually performed at the normal pressure (1 atm= 100 kPa). The Ga metal boat is heated to at least 800 °C so that Ga is molten. A gas introducing tube is provided on the upstream side of the reactor. From the gas introducing tube, a mixture gas of $H_2$ and HCl is blown into the Ga melt. Thus, GaCl is synthesized. GaCl is gaseous, and it moves on the downstream side to reach near the heated susceptor and the sample.

Near the susceptor, a mixture gas of $H_2$ and $NH_3$ is blown. Reaction between GaCl and $NH_3$ produces GaN, which is deposited on the sample.

The mask pattern to be formed on the ground substrate is only necessary to be of a material inhibiting the epitaxial growth. Exemplary mask materials may be $SiO_2$, SiON, SiN, Pt, W and the like. The mask becomes a seed of crystal defect gathering region H. The crystal orientation of GaN is determined by the ground substrate. The orientation of the mask determines the plane orientation of the facet along the mask. Therefore, it is necessary to form a mask that has a constant relationship with respect to the crystal orientation of the ground substrate.

Example 1 (the extent of polarity reversed region J formation by first growth temperature Tj)

1. Ground substrate (U)

As a ground substrate, 2-inch-diameter sapphire substrate (U1), GaAs substrate (U2), sapphire substrate (U3) on which a 1.5-$\mu$m-thick GaN epitaxial layer is formed through the MOCVD method were prepared. Sapphire substrate (U1) was a substrate of which main surface was C-plane ((0001) plane). GaAs substrate (U2) was a substrate of which main surface was (111) A-plane (i.e., Ga plane). GaN/sapphire substrate (U3) was a mirror-surface-like substrate in which GaN layer of the epitaxial layer was formed on C-plane ((0001) plane) of the sapphire substrate. Such a substrate provided with an epitaxial layer is also referred to as a template.

2. Mask Pattern (M)

On each of these three types of ground substrates U1, U2 and U3, a 0.1-$\mu$m-thick $SiO_2$ thin film was formed through the plasma CVD (Chemical Vapor Deposition) method. By photolithography and etching, mask patterns were formed. The mask patterns were two types, i.e., stripe type (M1) and dot type (M2).

(M1: Stripe Type Mask Pattern: Fig. 8A)

The parallel linear masks having a width as shown in Fig. 8A being formed on ground substrate U is referred to as stripe type (M1) mask pattern. The orientation was determined such that the extending direction of the stripes was <1-100> direction of the GaN epitaxial layer. The GaN epitaxial layer is a layer deposited after the mask formation. On the other hand, since there is a constant relationship between the orientation of ground substrate U and that of the GaN crystal deposited thereon, it may be adapted to the relationship relative to the orientation of ground substrate U. When a GaN film is grown on C-plane sapphire substrate(U1), the orientation is twisted by 90° around c-axis. As to the GaN crystal formed on (111) plane GaAs substrate (U2), care should be taken for the plane orientation correspondence, since a hexagonal crystal is grown on the threefold symmetry plane of the cubic crystal. A GaN crystal grown on the GaN epitaxial layer of GaN/sapphire substrate (U3) grows in the same crystal orientation as the GaN epitaxial layer. Therefore, by determining the orientation of the longitudinal direction of the mask in association with the orientation of ground substrate U, mask M can be set to extend in <1-100> orientation of the GaN epitaxial layer that is grown thereafter.

In the case of GaN/sapphire substrate (U3), the orientation of mask extending direction is determined to be parallel with <1-100> direction of the GaN crystal. In the case of (111) plane GaAs substrate (U2), the orientation of mask extending direction is determined to be parallel with <11-2> direction of the GaAs crystal. In the case of sapphire substrate (U1), the orientation of mask extending direction is determined to be parallel with <11-20> direction of the sapphire crystal.

In stripe type (M1) mask pattern, width of a stripe-like cover portion ($SiO_2$), i.e., s = 30 $\mu$m, and repetition pitch of the stripe-like cover portion and expose portion, i.e., p = 300 $\mu$m. The expose portions also extend parallel with each other, and its width, i.e., e = 270 $\mu$m. That is, p = e + s. The pitch means a distance from the center of the cover portion to the center of the adjacent cover portion. The area ratio of the expose portion: the cover portion is 9:1.

(M2: Dot Type Mask Pattern: Fig. 9A)

Dots each having a certain diameter aligned with prescribed intervals to form a line is regarded as one unit. A large number of the units are aligned in parallel with each other. Relative to a certain row of dots, an adjacent row of dots is formed such that dots thereof are present at the positions displaced half the pitch relative to the dots of the certain row. It is a pattern in which dots are present at the vertexes of a figure constituted of regular triangles arranged without a gap. This is shown in Fig. 9A. That is, it is a pattern of sixfold symmetry. The direction in which dots are aligned is determined to be parallel with, for example, <1-100> direction of a GaN crystal. While the GaN crystal is grown later also herein, the crystal orientation of ground substrate U and the crystal orientation of the GaN crystal have a certain relationship. Therefore, the direction of the mask pattern can be determined in association with the crystal orientation of ground substrate U so that the line of dots is parallel with <1-100> direction of the GaN crystal. When the ground substrate is sapphire substrate (U1), dots are aligned to be parallel with <11-20> direction. When the ground substrate is GaAs (111) substrate (U2), dots are aligned to be parallel with <11-2> direction.

Each dot (cover portion) is circular, dot diameter t = 50 $\mu$m, and dot pitch p = 300 $\mu$m, which is a distance between the centers of nearest dots. The length of the expose portion on a line connecting dots, i.e., f = 250 $\mu$m. The area of a unit regular triangle having three dots as the vertexes is 38971 $\mu$m$^2$. The area of one dot (cover portion) is 1963 $\mu$m$^2$. The area ratio of the expose portion: the cover portion is 19:1.

3. First Growth Temperature (Polarity Reversed Region Growth Temperature) Tj

A first growth temperature for growing polarity reversed region J is denoted by Tj. In the present Example, the following seven types of temperature as Tj were tested: $Tj_{(1)}$ = 850 °C (1123.15K), $Tj_{(2)}$ = 900 °C (1173.15K), $Tj_{(3)}$ = 920 °C (1193.15K), $Tj_{(4)}$ = 950 °C (1223.15K), $Tj_{(5)}$ = 970 °C (1243.15K), $Tj_{(6)}$ = 990 °C (1263.15K), $Tj_{(7)}$ = 1150 °C (1423.15K).

4. Other Crystal Growth Conditions

In the HVPE reactor, the above-described substrates with masks (six types of substrates with masks, in which three types of ground substrates U1, U2 and U3 are each provided with two types of mask patterns M1 and M2) were placed. Initially, a buffer layer of GaN was formed at a low temperature of about 500 °C (Tb = 500 °C (773.15K)), with $NH_3$ gas partial pressure $P_{NH3}$ = 0.2 atm (20 kPa) and HCl gas partial pressure $P_{HCl}$ = 2 × 10$^{-3}$ atm (0.2 kPa), and with a growth time of 15 minutes. The thickness of the buffer layer was 60 nm.

Thereafter, in each experiment, the temperature of the substrates was raised to respective first growth temperatures $Tj_{(1)}$ - $Tj_{(7)}$ and a first crystal region (polarity reversed region J) was grown over the mask and second crystal regions ZY were grown over the expose portion (Fig. 7(b)-(d)). It was specified that $NH_3$ gas partial pressure $P_{NH3}$ = 0.2 atm (20 kPa) and HCl gas partial pressure $P_{HCl}$ = 2 × 10$^{-2}$ atm (2 kPa). The growth time was 60 minutes. The average thickness of thus grown crystal was about 70 $\mu$m. No differences were observed among three types of ground substrates U1-U3. That is, the crystal growth rate was 70 $\mu$m/h and substantially constantly fixed thereto.

5. Crystal Growth for Allowing Polarity Reversed Region to be Generated

In light of past experience, it is known that the crystal growth for obtaining polarity reversed region J in which c-axis direction ([0001] direction) is rotated by 180° relative to regions (second crystal regions ZY) other than the polarity reversed region shows the following state.

Description is given referring to Fig. 7. Fig. 7(a) shows a state where mask M is formed on ground substrate U. The state is similar if the mask is stripe type mask M1 or dot type mask M2. Herein the case of stripe mask M1 is described. Although there are many parallel masks, only one mask is shown.

In the case of stripe type mask M1, growth of a gallium nitride crystal starts from the expose portion where mask M is not present. Without climbing on the mask, the crystal is formed in a thin-film manner over the entire expose portion. When the growth further progresses, a tilted plane of which lower end is the mask end is formed. This tilted plane further grows without climbing on the mask, to form a clear facet F (Fig. 7(b)). This facet F has, for example, {11-22} plane orientation, although it is dependent on the orientation of mask M. A crystal is not present over the mask, and facets F, F oppose to each other at both ends of mask M. The portion under the facet is low crystal defect region portion Z. C-plane growth region portion Y is present at the portion below C-plane.

When polarity reversed region J in which c-axis direction is reversed by 180° is formed, as a precursor a rough protrusion is produced in the middle of the tilted plane of facet F. This is referred to as polarity reversed crystal Q (Fig. 7(c)). As facets F are formed opposing to each other, polarity reversed crystals Q, Q are likewise formed opposing to each other. Polarity reversed crystal Q is the seed of polarity reversed region J. If polarity reversed crystal Q is not formed, polarity reversed region J is not formed later. The top plane of the protrusion (polarity reversed crystal Q) forms a tilt angle of about 25° - 30° between the horizontal plane (C-plane). Polarity reversed crystal Q (protrusion) formed on facet F is a crystal in which c-axis direction is reversed by 180° relative to the adjacent region portion under facet F (low crystal defect region Z). Since the crystal orientation is reversed, it becomes the seed of polarity reversed region J. Polarity reversed crystal Q is also grown, and the rough protrusion is enlarged. Then, polarity reversed crystals Q extending from the opposing facets F are integrated (Fig. 7(d)). By the integration of polarity reversed crystals Q as shown in Fig. 7(d), the portion over mask M is closed. Polarity reversed crystals Q are not in contact with mask M. They extend laterally from facets F, F and are integrated with each other.

The integrated portion becomes the seed of a crystal of the same orientation, which is grown in the longitudinal direction. Thus, over mask M, the crystal of the same crystal orientation as polarity reversed crystals Q is formed. Since polarity reversed crystals Q is a crystal in which c-axis direction is reversed, crystal defect gathering portion H formed thereon becomes polarity reversed region J. Over the expose portion on both sides of mask M, more higher crystal regions (second crystal regions ZY) already exist (Fig. 7(e)). The flat surface thereof is C-plane and the tilted plane thereof is facet F. The crystal of second crystal regions ZY formed on the expose portion has a great amount of dislocations occurred at the boundary between ground substrate U. The dislocations extend upwardly as the growth progresses. Without burying the facet and while maintaining facet F, the growth is continued.

As the growth direction of the crystal in facet F is in the normal line direction, dislocations also extend in the normal line direction of facet F as the crystal is grown. Therefore, the direction in which dislocations extend is orthogonally outward. It exactly extends toward crystal defect gathering region H over the mask. Dislocations reach crystal defect gathering region H and are absorbed thereby. The dislocations absorbed by crystal defect gathering region H do not return to the facet again. Since they do not return, dislocations in the crystal region immediately under the facet are reduced. In the second crystal region grown over the expose portion, the portion grown under the facet is referred to as low crystal defect region portion Z. While this portion initially has a large number of dislocations between the ground substrate, as the facet is grown, dislocations are expelled externally and accumulated in crystal defect gathering region H, whereby a low density of dislocation is gradually attained in that portion. In the growth of a GaN crystal, crystal orientation is determined by the relationship with the ground substrate. Accordingly, second crystal regions ZY grown over the expose portion of the ground substrate become a single crystal. Low crystal defect region portion Z grown under the facet in second crystal region ZY has a low density of dislocations and is a single crystal, and therefore it is also referred to as a low defect single crystal region portion. Such facet growth continues until the end. Then, dislocations are efficiently expelled from second crystal regions ZY grown over the expose portion, low crystal defect region portion Z becomes a further excellent quality crystal with a low density of dislocations. In some cases, C-plane growth region portion Y remains, besides low crystal defect region portion Z.

On the other hand, in some cases crystal defect gathering region H being polarity reversed region J is not successfully formed. It is expected that whether or not polarity reversed region J is generated is affected by a temperature, a growth rate, a gas flow rate, a ground substrate, a mask material and the like.

(1) In the case of $Tj_{(1)}$ = 850 °C (1123.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were intermittently present like a dashed line.

M2 (dot type mask): Polarity reversed regions were present in most of the dots.

(2) In the case of $Tj_{(2)}$ = 900 °C (1173.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were continuously present.
M2 (dot type mask): Polarity reversed regions were present over all of the dots.

(3) In the case of $Tj_{(3)}$ = 920 °C (1193.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were continuously present.
M2 (dot type mask): Polarity reversed regions were present over all of the dots.

(4) In the case of $Tj_{(4)}$ = 950 °C (1223.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were continuously present.
M2 (dot type mask): Polarity reversed regions were present over all of the dots.

(5) In the case of $Tj_{(5)}$ = 970 °C (1243.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were continuously present.
M2 (dot type mask): Polarity reversed regions were present over all of the dots.

(6) In the case of $Tj_{(6)}$ = 990 °C (1263.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were continuously present.
M2 (dot type mask): Polarity reversed regions were present over all of the dots.

(7) In the case of $Tj_{(7)}$ = 1150 °C (1423.15K)

Ground substrate: sapphire substrate (U1), GaAs substrate (U2), GaN/sapphire substrate (U3)
Mask pattern: stripe type mask (M1), dot type mask (M2)

Observation Result

M1 (stripe type mask): Polarity reversed regions were observed only partially.
M2 (dot type mask): The dots with polarity reversed regions were only partially present.

As above, depending on first growth temperature Tj, polarity reversed region J in which c-axis direction is reversed is generated or only partially generated. Generation of polarity reversed region J was examined with different conditions besides the temperature. Thus, it was found that, with a fixed growth rate (in the present Example, about 70 $\mu$m/h), first growth temperature Tj largely effects whether or not polarity reversed region J is generated.

Since polarity reversed region J was not easily generated in any of ground substrates U1-U3 having stripe type mask pattern (M1) or dot type mask pattern (M2) at first growth temperature $Tj_{(7)}$ = 1150 °C (1423.15K), this temperature can hardly be regarded as the appropriate growth temperature for the polarity reversed region at this growth rate. In the range of first temperature from $Tj_{(1)}$ = 850 °C (1123.15K) to $Tj_{(6)}$ = 990 °C (1263.15K), polarity reversed regions J were generated over most of or all of the mask patterns. Therefore, it can be seen that this 140 °C temperature range, from 850 °C to 990 °C, is at least appropriate as the polarity reversed region growth temperature at the growth rate 70 $\mu$m/h of the present Example.

In the range from first temperature $Tj_{(2)}$ = 900 °C (1173.15K) - $Tj_{(6)}$ = 990 °C (1263.15K), polarity reversed regions J were generated on all of the mask patterns. Therefore, it was found that the temperature range 900 °C - 990 °C is more suitable first growth temperature as the polarity reversed region growth temperature.

Example 2 (the difference by growth rate Vj)

Using the same reactor as Example 1 and varying the growth rate, on GaAs (111) substrate (U2) provided with stripe type mask (M1) and dot type mask (M2) by $SiO_2$ as in Example 1, a gallium nitride crystal was grown. The relationship between crystal growth rate Vj of the gallium nitride crystal and ease of formation of polarity reversed region J was examined.

In the HVPE reactor, the above-described substrates with masks (two types of substrates, in which one type of ground substrate U2 provided with two types of mask patterns M1 and M2) were placed. Initially, a buffer layer of GaN was formed at a low temperature of about 500 °C (Tb = 500 °C (773.15K)), with $NH_3$ gas partial pressure $P_{NH3}$ = 0.2 atm (20 kPa) and HCl gas partial pressure $P_{HCl}$ = $2 \times 10^{-3}$ atm (0.2 kPa), and with a growth time of 15 minutes. The thickness of the buffer layer was 60 nm.

Thereafter, the temperature was raised so that first growth temperature (polarity reversed region formation temperature) Tj = 940 °C (1213.15K), and a first crystal region (polarity reversed region J) was grown over the mask and second crystal regions ZY were grown over the expose portion. It was specified that $NH_3$ gas partial pressure $P_{NH3}$ = 0.2 atm (20 kPa), and HCl gas partial pressure $P_{HCl}$ was varied. How the status of polarity reversed region generation changed by varying the HCl gas partial pressure was examined.

HCl partial pressure: $P_{HCl(1)}$ = $7 \times 10^{-3}$ atm (0.7 kPa)
$P_{HCl(2)}$ = $1 \times 10^{-2}$ atm (1 kPa)
$P_{HCl(3)}$ = $1.5 \times 10^{-2}$ atm (1.5 kPa)
$P_{HCl(4)}$ = $2 \times 10^{-2}$ atm (2 kPa)
$P_{HCl(5)}$ = $3 \times 10^{-2}$ atm (3 kPa)
$P_{HCl(6)}$ = $4 \times 10^{-2}$ atm (4 kPa)

In the present Example, while $NH_3$ gas partial pressure $P_{NH3}$ was constantly at 0.2 atm, the growth rate varied as the HCl gas partial pressure was varied. As the HCl gas partial pressure was increased, growth rate Vj was increased. How the manner of generation of polarity reversed region J changed by the variation of the growth rate was examined.

(1) In the case Of $P_{HCl(1)}$ = $7 \times 10^{-3}$ atm (0.7 kPa)
Growth rate $Vj_{(1)}$ = 18 $\mu$m/h

Observation Result

M1 (stripe type mask): Polarity reversed regions were observed only partially.

M2 (dot type mask): The dots with polarity reversed regions were only partially present.

(2) In the case Of $P_{HCl(2)} = 1 \times 10^{-2}$ atm (1 kPa)
Growth rate $Vj_{(2)} = 32$ μm/h

Observation Result

M1 (stripe type mask): Polarity reversed regions were intermittently present like a dashed line.
M2 (dot type mask): Polarity reversed regions were generated over most of the dots.

(3) In the case of $P_{HCl(3)} = 1.5 \times 10^{-2}$ atm (1.5 kPa)
Growth rate $Vj_{(3)} = 48$ μm/h

Observation Result

M1 (stripe type mask): Polarity reversed regions were continuously present.
M2 (dot type mask): Polarity reversed regions were generated over all of the dots.

(4) In the case of $P_{HCl(4)} = 2 \times 10^{-2}$ atm (2 kPa)
Growth rate $Vj_{(4)} = 70$ μm/h

Observation Result

M1 (stripe type mask): Polarity reversed regions were continuously present.
M2 (dot type mask): Polarity reversed regions were generated over all of the dots.

(5) In the case of $P_{HCl(5)} = 3 \times 10^{-2}$ atm (3 kPa)
Growth rate $Vj_{(5)} = 102$ μm/h

Observation Result

M1 (stripe type mask): Polarity reversed regions were continuously present.
M2 (dot type mask): Polarity reversed regions were generated over all of the dots.

(6) In the case of $P_{HCl(6)} = 4 \times 10^{-2}$ atm (4 kPa)
Growth rate $Vj_{(6)} = 138$ μm/h

Observation Result

M1 (stripe type mask): Polarity reversed regions were observed only partially.
M2 (dot type mask): The dots with polarity reversed regions were only partially present.

From the above result, it was found that the status of generation of polarity reversed region J (first crystal region) in which c-axis direction is reversed by 180° relative to other regions (second crystal regions ZY) changes by varying growth rate Vj. When growth rate Vj was slower than 18 μm/h, polarity reversed region J was not easily formed over the mask (stripe type mask M1 and dot type mask M2). When growth rate Vj was faster than 138 μm/h also, polarity reversed region J was not easily formed over the mask.
In order for polarity reversed region J to be generated over the mask, it is appropriate that growth rate Vj is 25

μm/h - 120 μm/h. Here, the appropriate growth rate range was defined by the intermediate values between the growth rate value when the polarity reversed regions were greatly generated and the growth rate value when the polarity reversed regions were not easily formed and the amount thereof was small.

Example 3 (the difference by growth rate Vj, at the different growth temperature)

The present inventors repeatedly conducted the trials as described in Examples 1 and 2, and discovered that the ease of formation of the polarity reversed regions are dependent on the crystal growth temperature as well as on the crystal growth rate at the crystal growth temperature. In the following Example 3 et seq, ease of formation of polarity reversed region J by growth rate Vj at the growth temperature different than in Example 2 was examined.

Using the same reactor as Example 1, at the growth temperature different than in Example 2 and varying the growth rate, on GaAs (111) substrate (U2) provided with stripe type mask (M1) and dot type mask (M2) by $SiO_2$ as in Examples 1 and 2, a gallium nitride crystal was grown. The relationship between crystal growth rate Vj of the gallium nitride crystal and ease of formation of polarity reversed region J was examined.

In the HVPE reactor, the above-described substrates with masks (two types of substrates, in which one type of ground substrate U2 provided with two types of mask patterns M1 and M2) were placed. Initially, a buffer layer of GaN was formed at a low temperature of about 500 °C (Tb = 500 °C (773.15K)), with $NH_3$ gas partial pressure $P_{NH3}$ = 0.2 atm (20 kPa) and HCl gas partial pressure $P_{HCl}$ = $2 \times 10^{-3}$ atm (0.2 kPa), and with a growth time of 15 minutes. The thickness of the buffer layer was 60 nm.

Thereafter, the temperature was raised so that first growth temperature (polarity reversed region formation temperature) Tj = 1030 °C (1303.15K), and a first crystal region (polarity reversed region J) was grown over the mask and second crystal regions ZY were grown over the expose portion. It was specified that $NH_3$ gas partial pressure $P_{NH3}$ = 0.2 atm (20 kPa), and HCl gas partial pressure $P_{HCl}$ was varied. How the status of polarity reversed region generation changed by varying the HCl gas partial pressure was examined.

HCl partial pressure:  
$P_{HCl(1)}$ = $7 \times 10^{-3}$ atm (0.7 kPa)  
$P_{HCl(2)}$ = $1 \times 10^{-2}$ atm (1 kPa)  
$P_{HCl(3)}$ = $1.5 \times 10^{-2}$ atm (1.5 kPa)  
$P_{HCl(4)}$ = $2 \times 10^{-2}$ atm (2 kPa)  
$P_{HCl(5)}$ = $4 \times 10^{-2}$ atm (4 kPa)  
$P_{HCl(6)}$ = $6 \times 10^{-2}$ atm (6 kPa)  
$P_{HCl(7)}$ = $8 \times 10^{-2}$ atm (8 kPa)

In the present Example, while $NH_3$ gas partial pressure $P_{NH3}$ was constantly at 0.2 atm, the growth rate varied as the HCl gas partial pressure was varied. As the HCl gas partial pressure was increased, growth rate Vj was increased. How the manner of generation of polarity reversed region J changed by the variation of the growth rate was examined.

(1) In the case of $P_{HCl(1)}$ = $7 \times 10^{-3}$ atm (0.7 kPa)  
Growth rate $Vj_{(1)}$ = 22 μm/h  
Ground substrate: GaAs substrate (U2)

Observation Result

M1 (stripe type mask): Polarity reversed regions were observed only partially.  
M2 (dot type mask): The dots with polarity reversed regions were only partially present.

(2) In the case of $P_{HCl(2)}$ = $1 \times 10^{-2}$ atm (1 kPa)  
Growth rate $Vj_{(2)}$ = 38 μm/h  
Ground substrate: GaAs substrate (U2)

Observation Result

M1 (stripe type mask): Polarity reversed regions were observed only partially.  
M2 (dot type mask): The dots with polarity reversed regions were only partially present.

(3) In the case of $P_{HCl(3)} = 1.5 \times 10^{-2}$ atm (1.5 kPa)
Growth rate $Vj_{(3)} = 62$ $\mu$m/h
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(4) In the case of $P_{HCl(4)} = 2 \times 10^{-2}$ atm (2 kPa)
Growth rate $Vj_{(4)} = 85$ $\mu$m/h
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(5) In the case of $P_{HCl(5)} = 4 \times 10^{-2}$ atm (4 kPa)
Growth rate $Vj_{(5)} = 132$ $\mu$m/h
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(6) In the case of $P_{HCl(6)} = 6 \times 10^{-2}$ atm (6 kPa)
Growth rate $Vj_{(6)} = 158$ $\mu$m/h
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(7) In the case of $P_{HCl(7)} = 8 \times 10^{-2}$ atm (8 kPa)
Growth rate $Vj_{(7)} = 236$ $\mu$m/h
Ground substrate: GaAs substrate (U2)

Observation Result

M1 (stripe type mask): Polarity reversed regions were observed only partially.
M2 (dot type mask): The dots with polarity reversed regions were only partially present.

From the above result, it was found that the status of generation of polarity reversed region J (first crystal region) having c-axis direction reversed by 180° relative to other regions (second crystal regions ZY) changed by varying growth rate Vj. However, it was found that the relationship between the growth rate and the status of polarity reversed region J generation at the growth temperature of 1030°C (1303.15K) was different than at the growth temperature of 940°C (1213.15K) (Example 2). In the present Example where the growth temperature was high, polarity reversed region J was not easily generated over the mask (stripe type mask M1 and dot type mask M2) when growth rate Vj was slower than 38 $\mu$m/h. Conversely, when growth rate Vj was fast, polarity reversed region J was generated over the mask in a large amount, even at 158 $\mu$m/h. At 230 $\mu$m/h, generation of polarity reversed region J was reduced for the first time.

That is, it can be estimated that the appropriate growth rate for the polarity reversed regions to be generated is in a range from 50 $\mu$m/h to 197 $\mu$m/h, when the growth temperature is 1030°C (1303.15K). It was confirmed that this appropriate growth rate range has been wholly shifted toward higher rates than in the case where the growth temperature was 940°C (1213.15K).

Example 4 (the difference by growth rate Vj, at the different growth temperature)

In Example 3, the effective growth rate range with which polarity reversed region J was generated in the most part was obtained in the high temperature range of 1030°C (1303.15K). However, in Examples 1 and 2, the temperature at which polarity reversed region J was generated over the entire mask M was lower than the growth temperature of Example 3. Accordingly, ease of formation of polarity reversed region J by the difference in growth rate Vj was examined at growth temperature Tj around 940°C (1213.15K), which was near the growth temperature of Example 2.

Using the same reactor as Example 1, at the growth temperature different than in Example 2 and varying the growth rate, on GaAs (111) substrate (U2) provided with stripe type mask (M1) and dot type mask (M2) by $SiO_2$ as in Examples 1 and 2, a gallium nitride crystal was grown. The relationship between crystal growth rate Vj of the gallium nitride crystal and ease of formation of polarity reversed region J was examined.

In the HVPE reactor, the above-described substrates with masks (two types of substrates, in which one type of ground substrate U2 provided with two types of mask patterns M1 and M2) were placed. Initially, a buffer layer of GaN was formed at a low temperature of about 500 °C (Tb = 500 °C (773.15K)), with $NH_3$ gas partial pressure $P_{NH3}$ = 0.2 atm (20 kPa) and HCl gas partial pressure $P_{HCl}$ = $2 \times 10^{-3}$ atm (0.2 kPa), and with a growth time of 15 minutes. The thickness of the buffer layer was 60 nm.

Thereafter, the temperature was raised so that first growth temperature (polarity reversed region formation temperature) Tj = 960°C (1233.15K), and a first crystal region (polarity reversed region J) was grown over the mask and second crystal regions ZY were grown over the expose portion. It was specified that $NH_3$ gas partial pressure $P_{NH3}$ = 0.2 atm (20 kPa), and HCl gas partial pressure $P_{HCl}$ was varied. How the status of polarity reversed region generation changed by varying the HCl gas partial pressure was examined.

HCl partial pressure:    $P_{HCl(1)}$ = $7 \times 10^{-3}$ atm (0.7 kPa)
$P_{HCl(2)}$ = $1 \times 10^{-2}$ atm (1 kPa)
$P_{HCl(3)}$ = $1.5 \times 10^{-2}$ atm (1.5 kPa)
$P_{HCl(4)}$ = $2 \times 10^{-2}$ atm (2 kPa)
$P_{HCl(5)}$ = $2.5 \times 10^{-2}$ atm (2.5 kPa)
$P_{HCl(6)}$ = $3 \times 10^{-2}$ atm (3 kPa)
$P_{HCl(7)}$ = $4 \times 10^{-2}$ atm (4 kPa)

In the present Example, while $NH_3$ gas partial pressure $P_{NH3}$ was constantly at 0.2 atm, the growth rate varied as the HCl gas partial pressure was varied. As the HCl gas partial pressure was increased, growth rate Vj was increased. How the manner of generation of polarity reversed region J changed by the variation of the growth rate was examined.

(1) In the case of $P_{HCl(1)}$ = $7 \times 10^{-3}$ atm (0.7 kPa)
Growth rate $Vj_{(1)}$ = 20 $\mu$m/h
Ground substrate: GaAs substrate (U2)

Observation Result

M1 (stripe type mask): Polarity reversed regions were observed only partially.
M2 (dot type mask): The dots with polarity reversed regions were only partially present.

(2) In the case of $P_{HCl(2)}$ = $1 \times 10^{-2}$ atm (1 kPa)
Growth rate $Vj_{(2)}$ = 28 $\mu$m/h
Ground substrate: GaAs substrate (U2)

Observation Result

M1 (stripe type mask): Polarity reversed regions were observed only partially.
M2 (dot type mask): The dots with polarity reversed regions were only partially present.

(3) In the case of $P_{HCl(3)} = 1.5 \times 10^{-2}$ atm (1.5 kPa)
Growth rate $Vj_{(3)} = 42$ $\mu$m/h
Ground substrate: GaAs substrate (U2)

Observation Result

M1 (stripe type mask): Polarity reversed regions were intermittently present like a dashed line.

M2 (dot type mask): Polarity reversed regions were present over most of the dots.

(4) In the case of $P_{HCl(4)} = 2 \times 10^{-2}$ atm (2 kPa)
Growth rate $Vj_{(4)} = 65$ $\mu$m/h
Ground substrate: GaAs substrate (U2)

Observation Result

M1 (stripe type mask): Polarity reversed regions were continuously present.
M2 (dot type mask): Polarity reversed regions were present over all of the dots.

(5) In the case of $P_{HCl(5)} = 2.5 \times 10^{-2}$ atm (2.5 kPa)
Growth rate $Vj_{(5)} = 110$ $\mu$m/h
Ground substrate: GaAs substrate (U2)

Observation Result

M1 (stripe type mask): Polarity reversed regions were continuously present.
M2 (dot type mask): Polarity reversed regions were present over all of the dots.

(6) In the case of $P_{HCl(6)} = 3 \times 10^{-2}$ atm (3 kPa)
Growth rate $Vj_{(6)} = 130$ $\mu$m/h
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(7) In the case of $P_{HCl(7)} = 4 \times 10^{-2}$ atm (4 kPa)
Growth rate $Vj_{(7)} = 150$ $\mu$m/h
Ground substrate: GaAs substrate (U2)

Observation Result

M1 (stripe type mask): Polarity reversed regions were observed only partially.
M2 (dot type mask): The dots with polarity reversed regions were only partially present.

From the above result, it was again found that the status of generation of polarity reversed region J having c-axis direction reversed by 180° relative to other regions (second crystal regions ZY) changed by varying growth rate Vj.

However, it was found that the status of polarity reversed region J generation for growth rate Vj was different than at growth temperature Tj of 940°C (1213.15K). In the present Example with growth temperature Tj higher than Example 2 by 20°C, the polarity reversed regions were generated at the most part at growth rate Vj of 42 $\mu$m/h, polarity reversed region J was not easily generated over the mask (stripe type mask M1 and dot type mask M2) at the growth rate slower than 28 $\mu$m/h. Conversely, when growth rate Vj was fast, polarity reversed regions J were generated over the mask in a large amount even when growth rate $Vj_{(6)}$ = 130 $\mu$m/h. Generation of polarity reversed region J was reduced at growth rate $Vj_{(7)}$ = 150 $\mu$m/h for the first time.

That is, it can be regarded that the appropriate growth rate for the polarity reversed region to be generated is between 35 $\mu$m/h and 140 $\mu$m/h when growth temperature Tj is 960°C (1233.15K). Here, the appropriate growth rate range was defined by the intermediate values between the growth rate value when the polarity reversed regions were generated over the most part of mask M, and the growth rate value when the polarity reversed regions were not easily formed over the most part of mask M. It was confirmed that this appropriate growth rate range has been wholly shifted slightly toward higher rates than in the case where the growth temperature was 940°C.

Furthermore, since the polarity reversed regions were generated over the entire mask at growth rate $Vj_{(4)}$ = 65 $\mu$m/h and growth rate $Vj_{(5)}$ = 110 $\mu$m/h, it was confirmed that the temperature of the present example allows the polarity reversed region to be generated more easily than the case where first growth temperature Tj = 1030 °C (1303.15K).

Example 5 (the difference by growth rate Vj, at the different growth temperature)

For the same purpose as Example 4, ease of formation of polarity reversed region J by growth rate Vj at first growth temperature Tj of 920 °C (1193.15K) was examine in detail.

Using the same reactor as Example 1, at the growth temperature different than in Example 2 and varying the growth rate, on GaAs (111) substrate (U2) provided with stripe type mask (M1) and dot type mask (M2) by $SiO_2$ as in Examples 1 and 2, a gallium nitride crystal was grown. The relationship between crystal growth rate Vj of the gallium nitride crystal and ease of formation of polarity reversed region J was examined.

In the HVPE reactor, the above-described substrates with masks (U2; M1, M2) were placed. Initially, a buffer layer of GaN was formed at a low temperature of about 500 °C (Tb = 500 °C (773.15K)), with $NH_3$ gas partial pressure $P_{NH3}$ = 0.2 atm (20 kPa) and HCl gas partial pressure $P_{HCl}$ = 2 $\times$ 10$^{-3}$ atm (0.2 kPa), and with a growth time of 15 minutes. The thickness of the buffer layer was 60 nm.

Thereafter, the temperature was raised so that first growth temperature (polarity reversed region formation temperature) Tj = 920°C (1193.15K), and a first crystal region (polarity reversed region J) was grown over the mask and second crystal regions ZY were grown over the expose portion. It was specified that $NH_3$ gas partial pressure $P_{NH3}$ = 0.2 atm (20 kPa), and HCl gas partial pressure $P_{HCl}$ was varied. How the status of polarity reversed region generation changed by varying the HCl gas partial pressure was examined.

HCl partial pressure:     $P_{HCl(1)}$ = 7 $\times$ 10$^{-3}$ atm (0.7 kPa)
$P_{HCl(2)}$ = 1 $\times$ 10$^{-2}$ atm (1 kPa)
$P_{HCl(3)}$ = 1.5 $\times$ 10$^{-2}$ atm (1.5 kPa)
$P_{HCl(4)}$ = 2 $\times$ 10$^{-2}$ atm (2 kPa)
$P_{HCl(5)}$ = 4 $\times$ 10$^{-2}$ atm (4 kPa)
$P_{HCl(6)}$ = 5 $\times$ 10$^{-2}$ atm (5 kPa)

While $NH_3$ gas partial pressure $P_{NH3}$ was constantly at 0.2 atm, the growth rate varied as the HCl gas partial pressure was varied. As the HCl gas partial pressure was increased, growth rate Vj was increased. How the manner of generation of polarity reversed region J changed by the variation of the growth rate was examined.

(1) In the case of $P_{HCl(1)}$ = 7 $\times$ 10$^{-3}$ atm (0.7 kPa)
Growth rate $Vj_{(1)}$ = 14 $\mu$m/h
Ground substrate: GaAs substrate (U2)

Observation Result

M1 (stripe type mask): Polarity reversed regions were observed only partially.
M2 (dot type mask): The dots with polarity reversed regions were only partially present.

(2) In the case of $P_{HCl(2)} = 1 \times 10^{-2}$ atm (1 kPa)
Growth rate $Vj_{(2)} = 36 \ \mu m/h$
Ground substrate: GaAs substrate (U2)

Observation Result

M1 (stripe type mask): Polarity reversed regions were continuously present.
M2 (dot type mask): Polarity reversed regions were present over all of the dots.

(3) In the case of $P_{HCl(3)} = 1.5 \times 10^{-2}$ atm (1.5 kPa)
Growth rate $Vj_{(3)} = 55 \ \mu m/h$
Ground substrate: GaAs substrate (U2)

Observation Result

M1 (stripe type mask): Polarity reversed regions were continuously present.
M2 (dot type mask): Polarity reversed regions were present over all of the dots.

(4) In the case of $P_{HCl(4)} = 2 \times 10^{-2}$ atm (2 kPa)
Growth rate $Vj_{(4)} = 75 \ \mu m/h$
Ground substrate: GaAs substrate (U2)

Observation Result

M1 (stripe type mask): Polarity reversed regions were continuously present.
M2 (dot type mask): Polarity reversed regions were present over all of the dots.

(5) In the case of $P_{HCl(5)} = 4 \times 10^{-2}$ atm (4 kPa)
Growth rate $Vj_{(5)} = 110 \ \mu m/h$
Ground substrate: GaAs substrate (U2)

Observation Result

M1 (stripe type mask): Polarity reversed regions were intermittently present like a dashed line.
M2 (dot type mask): Polarity reversed regions were present over most of the dots.

(6) In the case of $P_{HCl(6)} = 5 \times 10^{-2}$ atm (5 kPa)
Growth rate $Vj_{(6)} = 130 \ \mu m/h$
Ground substrate: GaAs substrate (U2)

Observation Result

M1 (stripe type mask): Polarity reversed regions were observed only partially.

M2 (dot type mask): The dots with polarity reversed regions were only partially present.

From the above result, it was again found that the status of generation of polarity reversed region J having c-axis direction reversed by 180° relative to other regions (second crystal regions ZY) changed by varying growth rate Vj. Also, it was found that the status of polarity reversed region J generation for growth rate Vj was different than at growth temperature Tj of 940°C (1213.15K). In the present example where growth temperature Tj was lower than Example 2 by 20°C, the polarity reversed regions were generated over the entire mask at growth rate Vj of 36 $\mu$m/h, polarity reversed region J was not easily generated over the mask (stripe type mask M1 and dot type mask M2) at 14 $\mu$m/h. When growth rate Vj was fast, polarity reversed regions J were generated over the mask in a large amount up to 110 $\mu$m/h, and generation of polarity reversed region J is reduced at 130 $\mu$m/h.

That is, it can be estimated that the appropriate growth rate for the polarity reversed regions to be generated is in a range from 25 $\mu$m/h to 120 $\mu$m/h, when growth temperature Tj is 920°C (1233.15K). Here, the appropriate growth rate range was defined by the intermediate values between the growth rate value when the polarity reversed regions were generated over the most part of mask M, and the growth rate value when the polarity reversed regions were not easily formed over the most part of mask M. It was confirmed that, the appropriate growth rate range has been wholly shifted slightly toward lower rates than in the case where the growth temperature was 940°C (1213.15K).

Further, since the polarity reversed regions were generated over the entire mask in the three examples where growth rates Vj were 36 $\mu$m/h, 55 $\mu$m/h, and 75 $\mu$m/h, respectively, it was confirmed that the polarity reversed region was more easily generated than in the case where Tj = 1030°C (1303.15K).

As to the GaN crystal growth in Examples 1-5, the relationship between the first growth condition (the crystal growth temperature and the crystal growth rate) and the generation of the polarity reversed region is summarized in the graph of Fig. 10. In Fig. 10, the ordinate indicates the growth rate Vj ($\mu$m/h) and the abscissa indicates $1000/T(K^{-1})$ which is reciprocal of growth temperature T in absolute temperature multiplied by 1000. In Fig. 10, solid circles represent that the polarity reversed regions are generated over the entire mask, open circles represent that the polarity reversed regions are generated over most of the mask, and triangles represent that the polarity reversed regions are slightly generated over the mask. In the graph of Fig. 10, solid lines represent the upper limit line and the lower limit line between which polarity reversed region J is easily generated, based on the result of Examples 1-5. Here, lower limit line L1 is represented by Vj = ($-4.39 \times 10^5$ / T + $3.87 \times 10^2$), and upper limit line L2 is represented by Vj = ($-7.36 \times 10^5$ / T + $7.37 \times 10^2$). Accordingly, the first growth condition with which the polarity reversed region is easily formed is expressed by the following expression (ii):

$$(-4.39 \times 10^5 / T + 3.87 \times 10^2) < Vj < (-7.36 \times 10^5 / T + 7.37 \times 10^2) \dots \text{(ii)}$$

Referring to Fig. 10, it can be seen that in the first growth condition, the polarity reversed region is easily generated over the entire mask when growth temperature Tj expressed in Celsius degree is 900°C - 990°C. Accordingly, it is preferable that growth temperature Tj of the first growth condition expressed in Celsius degree is 900°C - 990°C. Further, from the same point of view, it is more preferable that growth temperature Tj of the first growth condition expressed in Celsius degree is 920°C - 960°C.

Example 6 (growth of a thick crystal after polarity reversed region formation)

The first growth was carried out according to Example 1 to form a polarity reversed region. Thereafter, the second growth (the growth for increasing the thickness of the GaN crystal) was carried out to grow a thick GaN film. The same reactor as Example 1 was used. As the ground substrate, a sapphire (0001) single crystal substrate was used.

As to the mask, stripe type mask M1 (Fig. 8A) and dot type mask M2 (Fig. 9A) were produced. The ground substrates respectively provided with the two types of masks were prepared. On each ground substrate, the a buffer layer growth and the first growth were carried out.

In the HVPE reactor, the above-described samples were placed. Initially, a buffer layer of GaN was formed at a low temperature of about 500 °C (Tb), with NH$_3$ gas partial pressure $P_{NH3}$ = 0.2 atm (20 kPa) and HCl gas partial pressure $P_{HCl}$ = $2 \times 10^{-3}$ atm (0.2 kPa), and with a growth time of 15 minutes. $P_{NH3}$ / $P_{HCl}$ = 100 . The thickness of the buffer layer was 60 nm.

Thereafter, the temperature was raised and the polarity reversed region was generated, in which first growth temperature Tj = 950°C (1223.15K). It was specified that NH$_3$ gas partial pressure $P_{NH3}$ = 0.2 atm (20 kPa), and HCl gas partial pressure $P_{HCl}$ = $2 \times 10^{-2}$ atm (2 kPa). $P_{NH3}$ / $P_{HCl}$ = 10. The period of the first growth was 45 minutes.

After the growth for generating the polarity reversed region, subsequently the GaN crystal was epitaxially grown under normal conditions. This is the second growth, in which second growth temperature Te = 1050°C (1323.15K). It was specified that NH$_3$ gas partial pressure P$_{NH3}$ =0.2 atm (20 kPa), and HCl gas partial pressure P$_{HCl}$ = 3 $\times$ 10$^{-2}$ atm (3 kPa). P$_{NH3}$ / P$_{HCl}$ = 6.7. The period of the second growth was 15 hours. The samples were cooled and taken out from the reactor. A GaN crystal of a 1.5 mm thickness was obtained.

The observation of the grown GaN crystal was conducted using a stereoscopic microscope and SEM. With the dot type mask, the parts corresponding to the dots were recesses. With the stripe type mask, the parts corresponding to the masks were recessed. The mask pattern and the position of recesses accurately corresponded to each other. The recess was constituted by the facet planes. At the bottom of the recess, facets with a smaller tilt angle than the upper faces were present.

The sapphire substrate was removed by grinding working to leave the GaN crystal. The surface was further subjected to grinding working and polishing working, and a GaN substrate having flat surfaces was obtained.

The surface the flat GaN substrate after polishing was evaluated by an optical microscope and cathode luminescence (CL).

It was found that, in the crystal substrate grown using stripe type mask (M1), linear recesses of 20 $\mu$m width and being parallel with each other with a regular pitch of 300 $\mu$m were present. The recesses were attributed to {11-2-6} plane appearing on the surface, whereby it was confirmed that crystal defect gathering region H was generated, and that crystal defect gathering region H was polarity reversed region J.

In the crystal substrate grown using dot type mask (M2) also, recesses having a diameter of about 30 $\mu$m - 40 $\mu$m were generated at the positions of sixfold symmetry with a pitch of 300 $\mu$m. They just corresponded to the mask positions. As shown in Fig. 9B, crystal defect gathering region H, low defect single crystal region Z and C-plane growth region Y formed a coaxial structure, around crystal defect gathering region H.

In CL image observation, threading dislocations exposed on the substrate surface appear as dark spots. The density of the threading dislocations can be measured by CL observation. The threading dislocation density was high in crystal defect gathering region H and was about 10$^7$ cm$^{-2}$- 10$^8$ cm$^{-2}$. The threading dislocation density was low in low crystal defect region portion Z between crystal defect gathering regions H and was about 1 $\times$ 10$^5$ cm$^{-2}$. Thus, low crystal defect region portion Z in which threading dislocation density was low enough was formed between adjacent crystal defect gathering regions H. It was a substrate of inhomogeneous composition.

A laser device can be produced at the portion of low crystal defect region portion Z. Thus, the gallium nitride substrate having low density of crystal defects with which a high-quality laser device could be produced was manufactured. In the substrate, although the dislocation density were not evenly low but high in some area (crystal defect gathering region H), wide low-crystal defect region portion Z was present. Therefore, the substrate was excellent for producing a device.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of growing a gallium nitride crystal, comprising:

   a step of partially forming, on a ground substrate (U), a mask (M) inhibiting epitaxial growth of a gallium nitride crystal to provide a cover portion covered by said mask (M) and an expose portion not covered by said mask (M); and
   a step of epitaxially growing said crystal by vapor phase deposition on said ground substrate (U) on which said mask (M) is formed, wherein
   in said step of epitaxially growing said crystal, said crystal is grown under a first growth condition wherein a growth rate Vj expressed in $\mu$m/h unit and a growth temperature T expressed in absolute temperature are expressed by

$$(a_1 / T + b_1) < Vj < (a_2 / T + b_2)$$

   using coefficients a$_1$ = -4.39 $\times$ 10$^5$, b$_1$ = 3.87 $\times$ 10$^2$, a$_2$ = -7.36 $\times$ 10$^5$, and b$_2$ =7.37 $\times$ 10$^2$,
   whereby said crystal is grown over said expose portion, a plurality of facets (F) of which end is periphery of said mask (M) are formed at said crystal over said expose portion, said crystal is grown with said facets (F) being maintained, a first crystal region is grown over said facets (F),opposite to each other with said mask (M) being interposed, so as to be integrated above said mask (M) and formed to cover said mask (M), and
c-axis direction of said first crystal region is reversed relative to a second crystal region grown over said expose portion.

2. The method of growing a gallium nitride crystal according to claim 1, wherein
in said step of epitaxially growing said crystal, said crystal is grown under said first growth condition, and said crystal is further grown with said facets (F) being maintained under a second growth condition of at least 990°C, whereby a low crystal defect region portion (Z) of said second crystal region is formed below said facets (F), and as said crystal is grown, dislocations in said low crystal defect region portion (Z) are reduced.

3. The method of growing a gallium nitride crystal according to claim 2, wherein
said second growth condition is 1000°C - 1200°C.

4. The method of growing a gallium nitride crystal according to claim 1, wherein
said first growth condition is a growth temperature Tj further expressed in Celsius degree being 900°C - 990°C.

5. The method of growing a gallium nitride crystal according to claim 4, wherein
in said step of epitaxially growing said crystal, said crystal is grown under said first growth condition, and said crystal is further grown with said facets (F) being maintained under a second growth condition of at least 990°C, whereby a low crystal defect region portion (Z) of said second crystal region is formed below said facets (F), and as said crystal is grown, dislocations in said low crystal defect region portion (Z) are reduced.

6. The method of growing a gallium nitride crystal according to claim 5, wherein
said second growth condition is 1000°C - 1200°C.

7. The method of growing a gallium nitride crystal according to claim 1, wherein
said first growth condition is a growth temperature Tj further expressed in Celsius degree being 920°C - 960°C.

8. The method of growing a gallium nitride crystal according to one of claims 1-7, further comprising
after the step of providing said cover portion and said expose portion to said ground substrate (U) and before said step of epitaxially growing said crystal, a step of providing a buffer layer of 30 nm-200 nm thickness over said expose portion at low temperature of 400°C - 600°C.

9. The method of growing a gallium nitride crystal according to one of claims 1-7, wherein
said ground substrate (U) is one of a sapphire single crystal substrate, a Si single crystal substrate, a SiC single crystal substrate, a GaN single crystal substrate, a GaAs single crystal substrate, and a sapphire single crystal substrate having a GaN thin film formed on its surface.

10. The method of growing a gallium nitride crystal according to one of claims 1-7, wherein
said step of epitaxially growing said crystal is performed by Hydride vapor phase epitaxy method.

# FIG.1

(a)

C-PLANE

AVERAGE GROWTH DIRECTION

(b)

AVERAGE GROWTH DIRECTION

C-PLANE

## FIG.2

MOVEMENT OF DISLOCATION IN FACET PIT

MOVEMENT OF DISLOCATION

MOVEMENT OF DISLOCATION

GROWTH DIRECTION

GROWTH DIRECTION

MOVEMENT OF DISLOCATION

MOVEMENT OF DISLOCATION

6 FACET

6 FACET

GROWTH DIRECTION

## FIG.3

(a)

GROWTH DIRECTION

DISLOCATION GATHERING BUNDLE

(b)

SMOKE-LIKE SPREAD

13 13

## FIG.4

(a)

GROWTH
DIRECTION

(b)

21    23 MASK

21    23 MASK

## FIG.5

(a)

(b)

(c)

FIG.6A

FIG.6B

# FIG.7

## FIG.8A

## FIG.8B

FIG.9A

FIG.9B

FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9923693 A
- JP 2001102307 A
- JP 2003165799 A
- JP 2003183100 A
- JP 2006066496 A